# FASCICULE DE BREVET EUROPEEN

(11) **EP 1 423 244 B1**
(45) Date de publication et mention de la délivrance du brevet: **21.03.2007**
(21) Numéro de dépôt: 02794609.4
(22) Date de dépôt: 24.07.2002
(51) Int. Cl.: B28D 1/32, B28D 5/00, H01L 21/00

(54) **DISPOSITIFS DE DECOLLEMENT DE SUBSTRATS ET PROCEDES ASSOCIES**
VORRICHTUNGEN ZUM ABTRENNEN VON SUBSTRATEN UND ZUGEHÖRIGE VERFAHREN
DEVICES FOR DETACHING SUBSTRATES AND THE ASSOCIATED METHODS

(30) Priorité: 07.08.2001 FR 0110537
(43) Date de publication de la demande: 02.06.2004
(73) Titulaire: S.O.I.Tec Silicon on Insulator Technologies, 38190 Bernin (FR)
(72) Inventeur: BARGE, Thierry, F-38000 Grenoble (FR); SCHWARZENBACH, Walter, F-38330 Saint Nazaire les Eymes (FR); WAECHTER, Jean-Marc, F-38660 Saint-Vincent-de-Mercuze (FR); TRUONG,Thuan, F-38420 Domène (FR); GHYSELEN, Bruno, F-38170 Seyssinet (FR)
(74) Mandataire: Texier, Christian
(86) Numéro de dépôt international: PCT/FR2002/002646
(87) Numéro de publication internationale: WO 2003/013815

(56) Documents cités:
- EP-A- 0 867 917
- EP-A- 0 977 242
- PATENT ABSTRACTS OF JAPAN vol. 016, no. 158 (E-1191), 17. April 1992 (1992-04-17) -& JP 04 010454 A (SANYO ELECTRIC CO LTD), 14. Januar 1992 (1992-01-14)
- PATENT ABSTRACTS OF JAPAN vol. 1997, no. 07, 31. Juli 1997 (1997-07-31) -& JP 09 069552 A (TOSHIBA CORP), 11. März 1997 (1997-03-11)
- PATENT ABSTRACTS OF JAPAN vol. 1996, no. 01, 31. Januar 1996 (1996-01-31) -& JP 07 240355 A (SUMITOMO SITIX CORP), 12. September 1995 (1995-09-12)

## Description

La présente invention concerne de manière générale le traitement des matériaux, et plus particulièrement de substrats pour l'électronique, l'optique ou l'optroélectronique.

Plus précisément, l'invention concerne un dispositif permettant de décoller, selon un plan de décollement, deux tranches de matériau initialement accolées l'une à l'autre conformément au préambule des revendications 1 et 21 (voir, par example, JP-A-07/240 355). Et l'invention concerne des procédés mis en oeuvre de tels dispositifs (voir revendications 15 et 30).

Comme on va le voir, l'invention s'applique à des tranches de matériau qui sont accolées ensemble avec des degrés de cohésion mécanique variables.

On précise que par « tranches accolées » on entend des tranches positionnées de manière à être en contact physique.

Et des tranches « accolées » peuvent ainsi :
- être encore reliées par des éléments de structure (c'est le cas notamment pour des tranches définisant entre elles un plan de fragilisation tel qu'évoqué ci-dessous, et qui ont subi un traitement - par exemple thermique - permettant de réaliser un clivage seulement partiel des deux tranches de part et d'autre du plan de fragilisation),
- ou au contraire n'être reliées par aucun élément structurel, mais rendues solidaires seulement par l'intermédiaire de forces telles que celles correspondant à un « effet ventouse » entre les surfaces accolées mais disjointes des deux tranches, et/ou de forces de Van der Waals (c'est la cas notamment pour des tranches initialement issues d'un même substrat, entre lesquelles on a défini un plan de fragilisation, et qui ont subi un traitement thermique ou autre permettant de réaliser un clivage complet entre les deux tranches de part et d'autre du plan de fragilisation).

Les deux tranches accolées forment ainsi un ensemble, que l'on appellera substrat.

Et outre le décollement des tranches lui-même, l'invention s'applique également à la manutention de telles tranches, après leur décollement.

On précise que l'invention s'applique à tous types de tranches de matériaux qui sont accolées ensemble et que l'on désire décoller de manière contrôlée et précise.

Ainsi, l'invention s'applique au décollement des tranches d'une structure de type SOI (acronyme correspondant à l'appellation anglo-saxonne de Silicon On Insulator pour silicium sur isolant), mais également de type SOA (acronyme correspondant à l'appellation anglo-saxonne de Silicon On Anything pour silicium sur matériau quelconque), ou même de type AOA (acronyme correspondant à l'appellation anglo-saxonne de Anything On Anything pour matériau quelconque sur matériau quelconque).

On précise toutefois qu'une application particulièrement avantageuse de l'invention, qui sera décrite ci-dessous à titre d'exemple non limitatif, concerne le décollement des tranches d'une structure de type SOI.

Un procédé de fabrication de substrats de type SOI qui est connu sous le nom générique de procédé SMARTCUT®, comprend les étapes principales suivantes :
- Une étape d'implantation d'espèces (ions ou atomes) à une profondeur donnée d'un substrat de matériau semiconducteur tel que du silicium monocristallin, afin de définir dans le substrat un plan de fragilisation,
- Une étape de fixation de ce substrat sur un raidisseur tel que par exemple du silicium éventuellement oxydé en surface, puis
- Une étape de clivage destinée à assurer au moins partiellement une fracture selon le plan de fragilisation défini au niveau de la couche d'espèces implantées. Une tranche se trouve ainsi de chaque côté de la fracture (une première tranche correspondant à la partie du substrat de silicium monocristallin qui a été détachée et éventuellement fixée sur le raidisseur, pour constituer le SOI, et une deuxième tranche qui correspond au reliquat de silicium).

Dans certains cas, si les deux tranches du substrat situées de part et d'autre du plan de fragilisation sont suffisamment épaisses pour présenter elles-mêmes un minimum de tenue mécanique, l'étape de fixation sur un raidisseur peut être omise.

On peut également faire croître directement un substrat de silicium sur le raidisseur, au lieu de fixer le substrat sur le raidisseur.

On trouvera un exemple de description générale d'un procédé de ce type dans le document FR 2 681 472.

Dans ce type de procédé, que la fracture qui est réalisée lors de l'étape de clivage soit complète ou partielle, les deux tranches restent dans la pratique en adhérence l'une à l'autre (par simple effet de ventouse dans le cas où la fracture a été complète, les faces des tranches étant extrêmement lisses).

Il demeure donc dans tous les cas nécessaire de finaliser leur décollement pour obtenir d'une part le substrat SOI final, et d'autre part le reliquat du silicium monocristallin, qui pourra être recyclé dans le procédé.

On rappelle par ailleurs que l'invention, si elle s'applique avantageusement au décollement de paires de tranches dont une tranche correspond à un SOI, et en particulier au décollement de telles paires de tranches issues d'un procédé SMARTCUT®, n'est pas limitée à cette application.

On retrouve ainsi dans de nombreuses structures à deux tranches cette problématique d'adhérence (ne serait ce que par effet ventouse) entre les deux tranches, qu'il faut alors décoller. Et l'invention s'applique ainsi au décollement des tranches de toute structure de type SOI, SOA ou AOA.

Dans le cas où les dimensions (épaisseur en particulier) des tranches les rendent fragiles, et/ou dans le cas où le matériau des tranches est délicat, un tel décollement des deux tranches doit naturellement être conduit avec les plus grandes précautions pour écarter les tranches l'une de l'autre, avec si nécessaire la réalisation ou l'achèvement de la fracture, sans risquer de détériorer les deux tranches.

Ceci est le cas en particulier dans le cas du décollement d'un substrat SOI d'avec son reliquat de silicium monocristallin, qui constitue comme on l'a dit une application préférée, bien que non limitative, de l'invention.

Dans cette application préférée, l'opération de décollement est en général effectuée manuellement, par un opérateur particulièrement expérimenté.

L'opérateur peut par exemple introduire dans le chant du substrat de silicium, à la hauteur du plan de clivage (qui correspond au plan de fragilisation), une lame acérée ou analogue permettant, par effet de coin, d'assurer le décollement des deux tranches.

Cette opération risque d'induire des chocs ou des frottements entre les faces en vis-à-vis des deux tranches, et donc de les détériorer.

En outre, cette opération manuelle est longue et fastidieuse, et les cadences de production en sont largement tributaires.

Enfin, notamment dans le cas où la fracture entre les deux tranches doit être terminée par le processus de décollement lui-même, les sollicitations apportées au substrat doivent être importantes, et l'opération manuelle évoquée ci-dessus devient inadaptée, voire dangereuse.

On comprend donc qu'il serait particulièrement avantageux de pouvoir proposer un procédé et un dispositif qui permettent de réaliser un décollement de manière rapide, fiable et reproductible, et qui en outre évite tout contact entre les faces des tranches lorsqu'elles sont en cours de décollement en vue de prévenir tout risque de rayure ou de dépôt de particules sur les faces desdites tranches.

La demande de brevet FR 98 13660 au nom de la Demanderesse expose un procédé et un dispositif qui visent à répondre à ce besoin.

Un objectif de la présente invention est de proposer encore une amélioration à ce procédé et à ce dispositif, qui soit en outre applicable au décollement de tranches de structures non seulement SOI, mais également SOA ou AOA.

En particulier, la présente invention vise à permettre d'augmenter encore les cadences de production qui peuvent être atteintes (par exemple dans le cas du décollement de substrats SOI).

L'invention vise également à permettre le décollement de tranches, en sollicitant le moins possible les faces de ces tranches qui sont opposées au plan de clivage entre les deux tranches.

Et l'invention vise également à permettre d'effectuer automatiquement les premières étapes de manutention des tranches de chaque substrat, après leur décollement.

On précise enfin qu'on connaît d'autres dispositifs visant à décoller les tranches d'un substrat semi-conducteur.

On connaît ainsi par le document EP 867 917 un dispositif visant à réaliser un décollement par jet de fluide.

On remarquera que la technologie mise en oeuvre pour réaliser ce décollement (jet de fluide) est spécifique, et correspond à une option bien particulière.

Une limitation liée à cette option est qu'il est nécessaire de prévoir des moyens sophistiqués pour maintenir le substrat à décoller de manière extrêmement précise en regard d'un jet de fluide qui vient attaquer le côté du substrat.

Et ce maintien nécessite de solliciter les faces de tranche que l'on désire décoller, ce qui peut générer des irrégularités dans la structure des tranches.

En outre, l'enseignement de ce document ne fournit pas de solution permettant de manutentionner simplement une pluralité de tranches que l'on vient de décoller.

JP 04 010 454 est également relatif à une technique de décollement par jet de fluide.

Ce document propose une séquence très spécifique visant à décoller individuellement les tranches de substrats.

En particulier, un retournement sélectif de certains substrats est prévu, ce qui complexifie le procédé de décollement.

EP 977 242 enseigne en outre une variante dans laquelle on utilise des ultrasons pour décoller les tranches d'un substrat.

Ici encore, la technologie retenue est très spécifique.

Et ici encore, des moyens tout à fait particuliers doivent être prévus, et un mode opératoire complexe est associé à ce traitement par ultrasons.

En particulier, il est nécessaire de placer le substrat à traiter dans une enceinte destinée à être exposée aux ultrasons, puis à retirer les tranches séparées de cette enceinte, ce qui correspond à des étapes de manutention fastidieuses.

On connaît par ailleurs le document JP 04-010454 lequel propose un dispositif visant à augmenter l'efficacité d'un traitement de substrats par diffusion.

On peut également citer pour information le document JP 09 069 552 comme document relatif au contexte très général de l'invention, mais ce document n'enseigne qu'un dispositif de manutention de substrats, et non de décollement.

Afin d'atteindre les buts mentionnés ci-dessus, l'invention propose selon un premier aspect un dispositif de décollement de substrat, selon la revendication 1,
➢ les mâchoires sont aptes à maintenir les substrats par suite du resserrement des mâchoires sur les substrats,

Des aspects préférés mais non limitatifs de ce dispositif sont les suivants :
- les deux mâchoires du premier ensemble de peigne sont identiques,
- dans chaque mâchoire du premier ensemble de peigne, les logements concaves des première et deuxième parties de mâchoire comprennent un élément saillant central tel qu'une arête, destiné à engager un substrat au niveau de son plan de clivage, ledit élément saillant définissant un plan général dans lequel il s'étend,
- dans chaque mâchoire du premier ensemble de peigne:
   ➢ chaque logement concave de la première partie de mâchoire présente en outre un profil asymétrique et comprend de part et d'autre dudit élément saillant:
   ➢ une première paroi orientée avec une première incidence générale par rapport au plan général dudit élément saillant, pour coopérer avec un premier côté du substrat, et
   ➢ une deuxième paroi orientée avec une deuxième incidence générale par rapport au plan général dudit élément saillant, qui est plus importante que ladite première incidence générale, pour coopérer avec un deuxième côté du substrat,
   ➢ de sorte que lors du resserrement des premières parties des mâchoires du premier ensemble de peigne sur le substrat, la tranche du substrat qui se trouve du premier côté du substrat dispose, par rapport auxdites premières parties et selon la direction perpendiculaire au plan général dudit élément saillant, d'un degré de liberté de mouvement moindre que celui dont dispose la tranche du substrat qui se trouve du deuxième côté du substrat,
- dans chaque mâchoire du premier ensemble de peigne:
   ➢ chaque logement concave de la deuxième partie de mâchoire présente en outre un profil asymétrique et comprend de part et d'autre dudit élément saillant :
      ✔ une première paroi orientée avec une première incidence générale par rapport au plan général dudit élément saillant, pour coopérer avec ledit deuxième côté dudit substrat, et
      ✔ une deuxième paroi orientée avec une deuxième incidence générale par rapport au plan général dudit élément saillant, qui est plus importante que ladite première incidence générale, pour coopérer avec ledit premier côté dudit substrat,
   ➢ de sorte que lors du resserrement des deuxièmes parties des mâchoires du premier ensemble de peigne sur le substrat, la tranche du substrat qui se trouve du deuxième côté du substrat dispose, par rapport auxdites deuxièmes parties et selon la direction perpendiculaire au plan général dudit élément saillant, d'un degré de liberté de mouvement moindre que celui dont dispose la tranche du substrat qui se trouve du premier côté du substrat,
   ➢ de manière à solliciter les deux tranches en écartement lors du resserrement du premier ensemble de peigne sur le substrat,
- dans chaque mâchoire du premier ensemble de peigne la première partie comprend deux membres agencés de part et d'autre de la deuxième partie,
- dans chaque mâchoire du premier ensemble de peigne la deuxième partie est mobile par rapport à la première partie,
- les moyens pour réaliser un déplacement contrôlé de certaines tranches de substrats après leur décollement comprennent des moyens de déplacement relatif en translation de la deuxième partie de chaque mâchoire par rapport à la première partie de chaque mâchoire respective, selon une direction perpendiculaire au plan général dudit élément saillant,
- le dispositif comprend en outre un deuxième ensemble de peigne, dont les mâchoires peuvent être resserrées sur les substrats indépendamment des première et deuxième parties,
- le deuxième ensemble de peigne comporte en outre une pluralité de passages pour laisser passer certaines tranches,
- le dispositif comprend en outre trois stations, dont une première station pour recevoir au moins un substrat à décoller, et deux stations pour recevoir chacune une tranche respective de chaque substrat décollé,
- le ou les ensemble(s) de peigne est (sont) monté(s) mobile(s) par rapport aux stations et il est prévu des moyens pour déplacer le(s)dit(s) ensemble(s) de peigne en regard de chaque station, sélectivement,
- chaque station est pourvue d'un poussoir respectif,
- le poussoir associé à la première station comporte des logements pour recevoir des substrats, le poussoir associé aux autres stations comportant des logements pour recevoir respectivement une des tranches issues du décollement de chaque substrat,
- chaque logement du poussoir associé à la première station comporte en outre un élément saillant dans sa région médiane, pour engagement au niveau du plan de clivage du substrat. On propose, en outre, un dispositif selon l'invention conformément à la revendication 21. Des aspects préférés de ce dispositif sont les suivants:

- ledit séparateur a une section transversale en forme de coin saillant,
- le dispositif comprend au moins deux stations, dont une station dédiée au décollement et une station dédiée au déchargement des tranches décollées,
- chaque station est pourvue d'un poussoir respectif,
- le poussoir de la station dédiée au décollement comporte des logements destinés à recevoir les substrats, logements dont la section présente un profil de forme générale en « V »,
- la forme détaillée desdits logements du poussoir est en « W », une arête centrale étant prévue au fond de chaque logement,
- le dispositif comprend également un deuxième peigne, dont les mâchoires peuvent être resserrées sur les substrats indépendamment des première et deuxième parties,
- le deuxième peigne comporte en outre une pluralité de passages pour laisser passer certaines tranches,
- le dispositif comprend également un guide destiné à positionner les substrats de façon précise

Selon un autre aspect de l'invention, on propose un procédé de décollement des tranches de substrats selon la revendication 15. Le procédé comprend la
- lors dudit resserrement, la coopération de forme des logements des premières parties des deux mâchoires provoque en outre un décalage contrôlé entre les deux tranches de chaque substrat, selon une direction perpendiculaire au plan de clivage,
- le décollement est réalisé lors dudit décalage contrôlé,
- suite audit resserrement on desserre les première et deuxième parties des mâchoires du premier ensemble de peigne de manière à relâcher les tranches séparées, et on resserre des mâchoires d'un deuxième ensemble de peigne, de manière à retenir uniquement certaines tranches de substrat,
- on retient une tranche de chaque substrat, l'autre tranche étant récupérée par un poussoir, et pour chaque substrat décollé on dépose la première tranche décollée dans un premier contenant, et la deuxième tranche décollée dans un deuxième contenant.

On propose en outre un procédé de décollement des tranches d'un substrat selon la revendication 30.

Ce produit comprend, en particulier, les étapes suivantes :
- préalablement au resserrement des mâchoires on maintient les tranches décollées dans des logements de poussoir en forme générale de « V »,
- préalablement au décollement on maintient les substrats à l'aide d'un guide,
- suite au resserrement desdites mâchoires permettant de maintenir les tranches, on resserre sur ces mêmes tranches d'autres mâchoires permettant de retenir seulement certaines tranches,
- on retient une tranche de chaque substrat, l'autre tranche étant récupérée par un poussoir, et pour chaque substrat décollé on dépose la première tranche décollée dans un premier contenant, et la deuxième tranche décollée dans un deuxième contenant.

Selon un autre aspect, l'invention propose également l'application d'un procédé tel que mentionné ci-dessus, pour le décollement de substrats issus d'un procédé de type SMARTCUT®, une première tranche du substrat correspondant à un SOI, l'autre tranche correspondant à un reliquat de matériau semiconducteur tel que du silicium monocristallin.

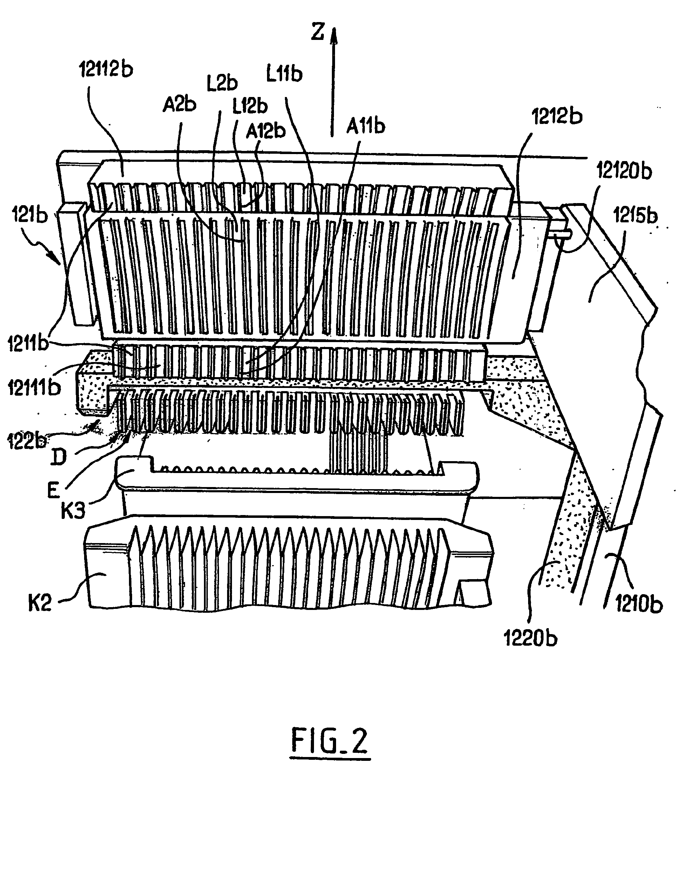

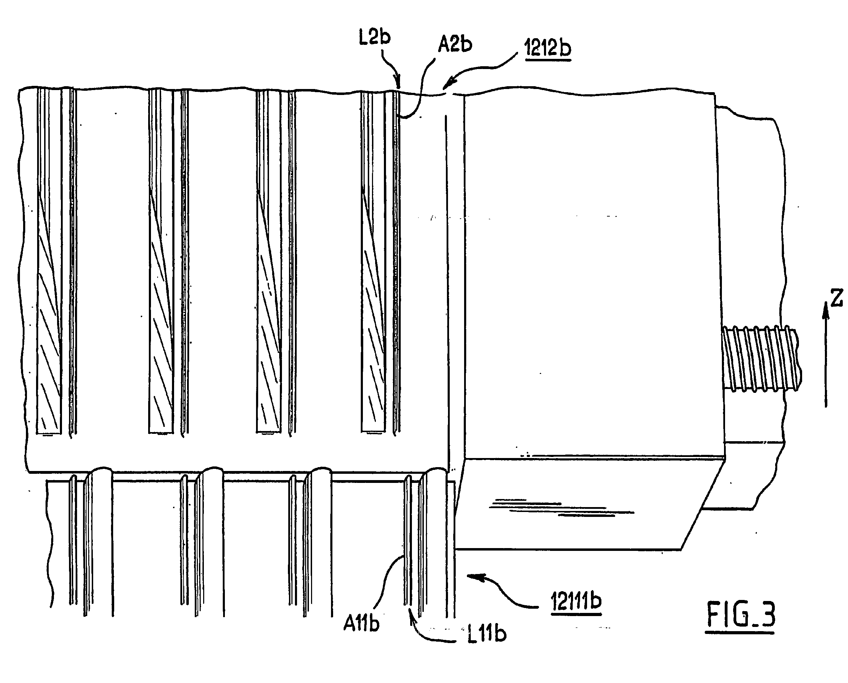

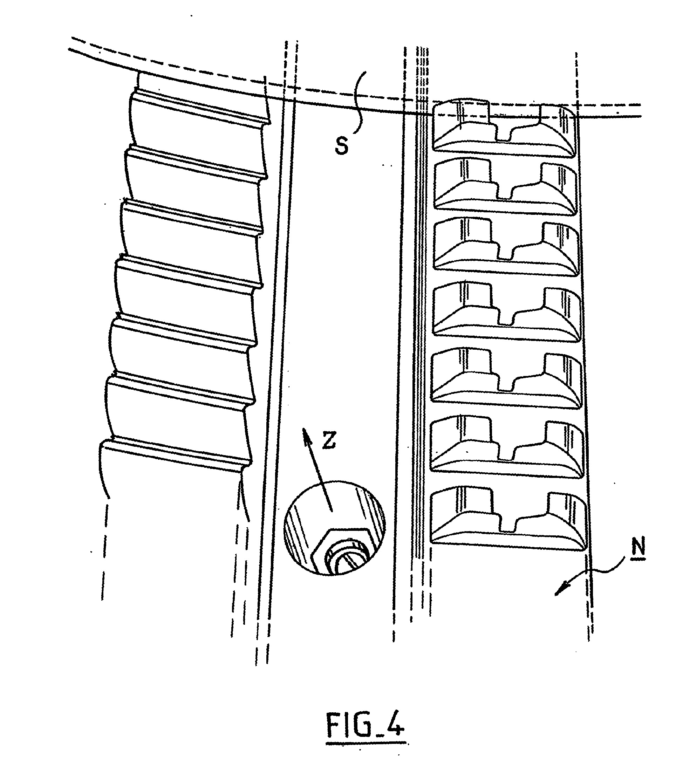

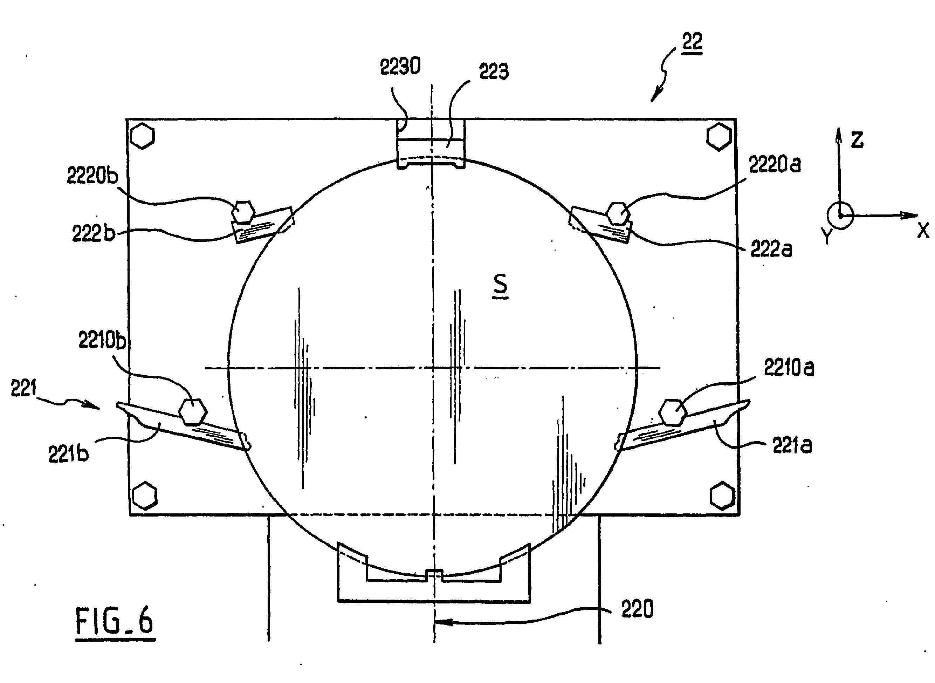

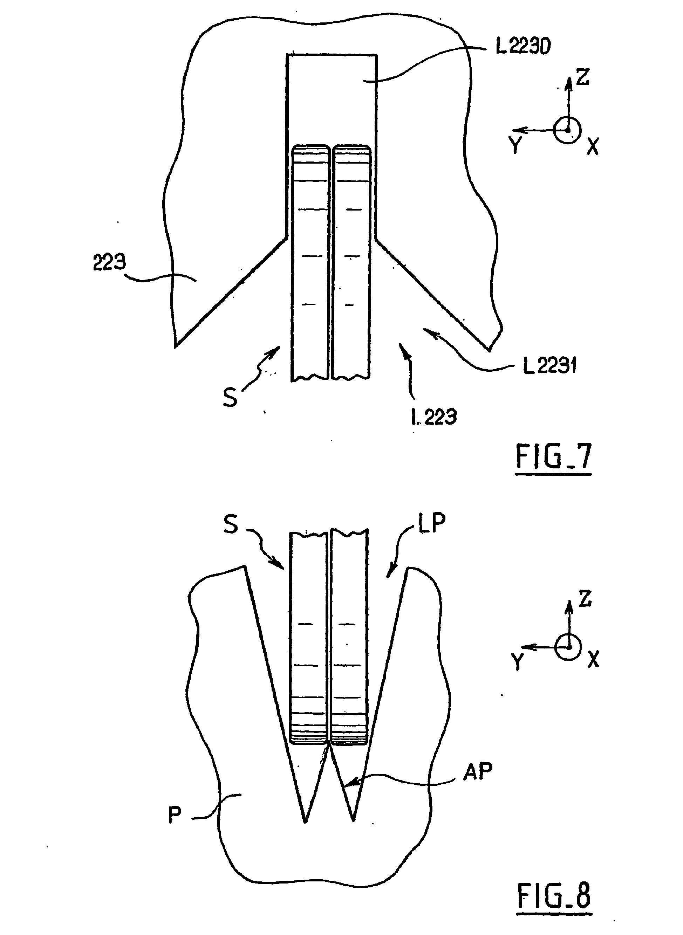

D'autres aspects, buts et avantages de l'invention apparaîtront mieux à la lecture de la description suivante de formes préférées de réalisation de l'invention, faite en référence aux dessins annexés sur lesquels :

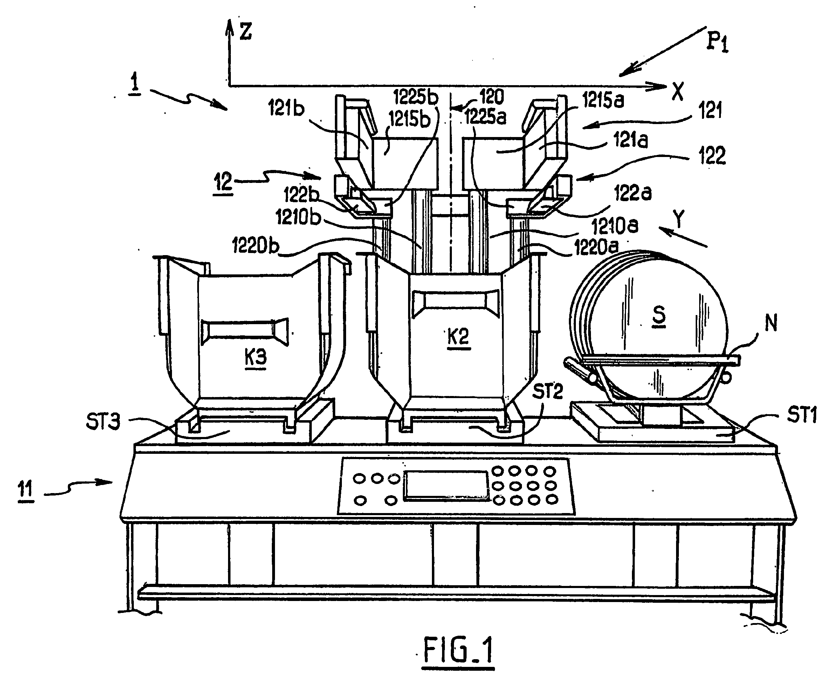

- Les figures 1 à 4 sont des vues d'une première machine permettant de mettre en oeuvre l'invention selon un premier mode principal de réalisation de l'invention. Plus précisément, sur ces figures :
   ➢ La figure 1 est une vue de devant schématique d'ensemble de la première machine, sur laquelle une direction de perspective P1 est définie,
   ➢ La figure 2 est une vue plus détaillée d'une partie de la première machine, selon la perspective P1,
   ➢ La figure 3 est une vue encore plus détaillée de deux éléments de la première machine représentés sur la figure 2,
   ➢ La figure 4 est une vue de détail d'une autre partie de la première machine,

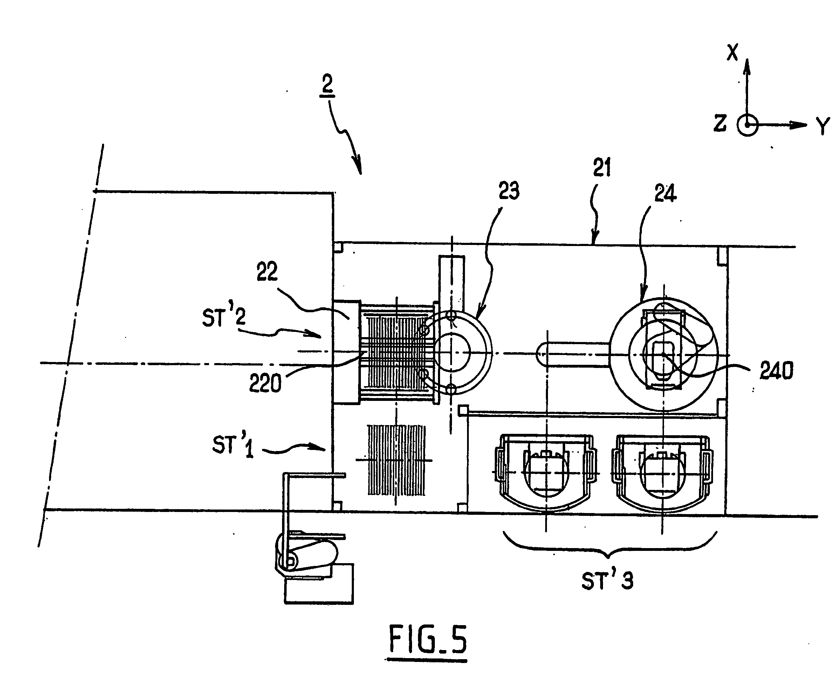

- Les figures 5 à 8 sont des vues d'une autre machine permettant de mettre en oeuvre l'invention selon un deuxième mode principal de réalisation de l'invention. Plus précisément, sur ces figures :
   ➢ La figure 5 est une représentation schématique d'ensemble de la deuxième machine, en élévation de dessus,
   ➢ La figure 6 est une représentation schématique d'un substrat positionné par rapport à certains éléments essentiels de la deuxième machine,
   ➢ Les figures 7 et 8 sont deux représentations schématiques d'un substrat, illustrant le positionnement dudit substrat par rapport à certains éléments de la deuxième machine.

La description qui suit va être faite en référence à une application préférée de l'invention, qui concerne le décollement de substrats comportant un plan de clivage définissant deux tranches, une tranche correspondant à un SOI ou un SOA (acronyme de Silicon On Anything pour silicium sur un matériau quelconque), alors que l'autre tranche correspond au reliquat de silicium.

On rappelle toutefois ici encore que l'invention n'est pas limitée à cette application : l'invention peut ainsi également concerner tout substrat correspondant à une structure de type SOI, SOA mais également AOA, et comportant deux tranches séparées par un plan de clivage (le clivage pouvant être pratiquement achevé de sorte que les deux tranches ne restent accolées l'une à l'autre que par un effet ventouse, le clivage pouvant également être à achever car d'autres forces de cohésion - pouvant résulter de l'existence de liens structurels - demeurent entre les deux tranches).

On précise également que les tranches des substrats à décoller peuvent être homogènes, ou non. En particulier, ces tranches peuvent comprendre des composants électroniques ou électro-optiques, lesdits composants pouvant être à l'état fini, ou intermédiaire.

Revenant à l'application préférée de l'invention, chacun des substrats à décoller (c'est à dire dont on souhaite décoller les deux tranches) a typiquement subi les étapes principales du procédé SMARTCUT® telles que décrites ci-dessus.

Une première tranche correspond ainsi à un SOl, l'autre tranche correspondant à un reliquat de matériau semiconducteur tel que du silicium monocristallin.

La première tranche peut également correspondre à un SOA, dans le cas où la fine tranche de silicium que l'on a constituée dans le substrat de silicium par la création du plan de clivage et l'opération de clivage elle-même est associée à un raidisseur de type quelconque (quartz ou autre).

En tout état de cause, on souhaite traiter des substrats comportant deux tranches situées de part et d'autre d'un plan de clivage, de manière à décoller les deux tranches l'une de l'autre.

En référence maintenant à la figure 1, on a représenté de manière schématique une machine 1 correspondant à un premier mode principal de réalisation de l'invention.

On précise en référence à toutes les figures que la direction verticale est représentée si besoin par la direction Z.

La machine 1 comprend une base fixe 11, représentée dans la partie basse de la figure. La base 11 est surmontée d'un ensemble 12, qui est mobile selon une direction X liée à la machine.

Sur la base 11 sont définies trois stations ST1, ST2 et ST3, l'ensemble mobile 12 étant apte à se déplacer en regard de chacune des trois stations.

La station ST1 est destinée à accueillir une nacelle de quartz N, qui peut contenir une pluralité de substrats S. Une contenance typique de la nacelle, correspondant à l'exemple de la figure 1, est de 25 substrats (la figure 1 en représentant moins, dans un simple but de clarté).

Les substrats peuvent avoir un diamètre de 200 mm.

Les substrats S sont alignés dans la nacelle selon une direction de rangement de substrats Y.

Des logements régulièrement répartis selon la direction de rangement des substrats sont prévus à cet effet dans la nacelle, de sorte que les substrats sont répartis régulièrement selon un pas de référence (« pitch » selon la terminologie anglo-saxonne) donné.

La nacelle N peut être issue directement d'un four dans lequel les substrats S ont subi un traitement thermique en vue de provoquer ou préparer le clivage de chaque substrat en deux tranches (une tranche de SOI ou SOA, et une tranche de reliquat de silicium).

Et comme on l'a dit, le clivage de ces substrats en deux tranches doit être finalisé (c'est à dire que l'on doit maintenant décoller les deux tranches l'une de l'autre).

Comme on va le voir, la machine permet ainsi de décoller la pluralité de substrats.

Et le décollement de la pluralité de substrats peut en outre être réalisé simultanément, ou avec un pas temporel contrôlé entre le décollement de deux substrats voisins. En tout état de cause, on améliore ainsi sensiblement les cadences de décollement atteintes avec les procédés et dispositifs connus.

Les stations ST2 et ST3 sont destinées à accueillir deux cassettes respectives K2 et K3.

Les cassettes K2 et K3 sont du type habituellement utilisé pour contenir et transporter des tranches de silicium.

Et ces cassettes comportent elles aussi des logements régulièrement disposés sur la longueur de leurs parois internes selon le même pas que le pas de référence des logements de la nacelle, pour recevoir les tranches issues du décollement des substrats qui étaient contenus dans la nacelle N (on va expliquer plus en détail ci-dessous le déroulement du procédé de décollement).

Chaque cassette comporte ainsi le même nombre de logements que la nacelle (25 en l'occurrence), chaque logement d'une cassette devant recevoir une des deux tranches issues du décollement d'un substrat.

La nacelle N et les deux cassettes sont disposées sur leurs stations respectives de sorte que la direction de rangement des substrats de la nacelle soit parallèle à la direction de rangement des tranches dans les deux cassettes.

On remarquera cependant que les deux cassettes sont disposées « tête bêche » ; en effet le H-BAR de la cassette K2 est orienté vers l'avant de la machine (c'est à dire qu'il nous fait face sur la représentation de la figure 1), alors que le H-BAR de la cassette K3 est orienté vers l'arrière de la machine.

Le H-BAR de la nacelle est quant à lui orienté vers l'avant de la machine.

On rappelle que le H-BAR définit par convention le côté d'un contenant (nacelle ou cassette par exemple) qui correspond aux « faces arrières » des substrats ou tranches qui sont dans ce contenant.

Ainsi, dans un tel contenant tous les substrats ou toutes les tranches sont disposé(e)s parallèlement selon une direction de rangement, la face arrière de chaque substrat ou chaque tranche étant tournée du côté du H-BAR du contenant.

On rappelle également que la face arrière d'un substrat est la face opposée à la face active, sur laquelle on désire réaliser des traitements spécifiques (constitution de structures électroniques, optiques, ...).

Et dans chaque cassette sont prévus des logements régulièrement espacés selon la direction de rangement des tranches, selon un pas égal au pas de référence défini par la nacelle N pour recevoir les tranches.

A chaque station ST1, ST2, ST3 est associé un poussoir (« pusher » selon la terminologie anglo-saxonne répandue), qui est sur la figure 1 escamoté dans la base 11.

Le poussoir de chaque station peut être déployé vers le haut pour s'engager dans des ouvertures laissées libres entre les éléments de structure portant les logements dans la partie basse de la nacelle (pour le poussoir de la station ST1) ou de la cassette (pour les poussoirs des stations ST2 et ST3), et venir soulever les substrats ou les tranches de leur nacelle ou cassette associé(e).

Chaque poussoir peut ainsi « traverser » sa nacelle ou cassette associée vers le haut pour « cueillir » les substrats ou tranches qui y étaient contenu(e)s.

A cet égard, les poussoirs sont également munis de logements concaves qui s'étendent de manière régulièrement espacée, selon la direction de rangement des substrats ou des tranches, avec le même pas que mentionné précédemment pour les poussoirs associés à ST1 et ST3 (ces poussoirs comprenant 25 logements), et avec un pas égal à la moitié de ce pas de référence pour le poussoir associé à ST2 (ce poussoir comprenant 50 logements).

Et le fond de chaque logement du poussoir qui est associé à la station ST1 et à la nacelle N comprend une arête saillante qui s'étend selon l'axe du logement au milieu de la concavité de celui-ci, pour cueillir le substrat au niveau de sa zone de clivage, ladite zone de clivage formant à la périphérie du substrat une cavité annulaire dans laquelle l'arête du poussoir s'engage.

Les poussoirs peuvent également redescendre avec des substrats ou des tranches, et déposer ces substrats ou tranches dans la nacelle ou cassette associée, en traversant les ouvertures des éléments de structure vers le bas, les éléments de structure interceptant les substrats ou tranches en les recueillant de manière ordonnée dans les logements alors que le poussoir poursuit sa course vers le bas jusqu'à être escamoté dans la base 11.

L'ensemble mobile 12 est monté par exemple sur des rails qui courent parallèlement à la direction X, des moyens de commande du déplacement de cette partie étant prévus.

Cet ensemble mobile 12 comprend deux parties principales 121 et 122, qui sont toutes deux agencées de manière symétrique de part et d'autre d'un plan médian 120 de l'ensemble 12.

Chaque partie 121, 122 comprend ainsi de chaque côté du plan 120 une mâchoire apte à être déplacée selon un arc de cercle dans un plan horizontal (c'est à dire parallèlement au plateau de la base 11), par rotation autour d'un bras vertical qui porte la mâchoire.

Ainsi, la première partie de l'ensemble 12 comprend deux mâchoires 121 a, 121 b qui sont montées à rotation dans le plan horizontal sur des bras respectifs 1210a, 1210b, par l'intermédiaire de supports de mâchoires respectifs 1215a, 1215b qui forment avec leur mâchoire associée un angle droit.

Les deux bras 1210 a et 1210b sont aptes à effectuer des rotations partielles autour de leur axe de symétrie respectif, pour entraîner en rotation les supports 1215a et 1215b, et les mâchoires 121a et 121b qui sont rigidement solidaires de ces supports respectifs.

Et ces rotations des deux bras 1210a et 1210b sont synchronisées, de sorte que les deux mâchoires 121a et 121b sont toujours positionnées de manière symétrique par rapport au plan médian 120, qui est fixe par rapport à l'ensemble 12.

Comme on le verra plus en détail en référence aux figures 2 et 3, ces deux mâchoires comprennent, sur leurs faces qui peuvent se trouver en regard lorsque les mâchoires 121 a et 121b sont dans la position fermée de la figure 1, des logements de géométrie bien particulière, répartis avec le même pas de référence que mentionné précédemment, selon leur longueur.

Les logements des membres 121a et 121 b ne sont pas représentés sur la vue schématique de la figure 1.

Ainsi, ces mâchoires constituent plus précisément les deux mâchoires articulées d'un peigne 121, ces deux mâchoires articulées pouvant se rapprocher pour refermer le peigne, ou s'écarter pour l'ouvrir.

On précise qu'on définit la direction de la longueur de ces mâchoires comme la direction du plan horizontal qui est parallèle à la direction de rangement des substrats et des tranches lorsque la nacelle et les cassettes sont disposées comme représenté sur la figure 1, et lorsque lesdites mâchoires 121a et 121b sont en position fermée (comme représenté sur la figure1).

L'ensemble 12 comporte ainsi un premier peigne 121.

L'ensemble 12 comporte de manière généralement similaire un deuxième peigne 122, situé en dessous du premier peigne 121.

Le deuxième peigne 122 est constitué des mâchoires 122a et 122b, qui comme les mâchoires 121 a et 121 b, sont montées à rotation dans un plan horizontal.

Les mâchoires 122a et 122b sont ainsi montées fixement sur les bras respectifs 1220a et 1220b, par l'intermédiaire des supports respectifs 1225a et 1225b auxquels les mâchoires respectives 122a et 122b sont rigidement liées.

Les deux bras 1220a et 1220b s'étendent verticalement et peuvent effectuer des rotations partielles autour de leur axe longitudinal.

Ici encore, les rotations des deux bras sont synchronisées pour que les deux mâchoires 122a et 122b soient toujours positionnées symétriquement par rapport au plan médian 120.

Et ces deux mâchoires 122a et 122b comprennent également, sur leurs faces qui peuvent se trouver en regard lorsque les mâchoires 122a et 122b sont dans la position fermée de la figure 1, des logements (non représentés sur la vue schématique de la figure 1) répartis avec le même pas de référence que mentionné précédemment, selon leur longueur.

La géométrie de ces logements est toutefois différente de la géométrie spécifique des logements des mâchoires du peigne 121, comme cela sera exposé plus en détail.

Les deux peignes 121 et 122 sont indépendants l'un de l'autre, et l'ouverture et la fermeture des mâchoires de chacun de ces deux peignes peuvent être commandées séparément et indépendamment, par des moyens de commande dédiés.

En référence maintenant à la figure 2, on a représenté plus en détail les mâchoires 121 b et 122b des peignes respectifs 121 et 122, dans une vue schématique de perspective selon la direction P1 définie sur la figure 1.

Et on rappelle que l'ensemble 12 est symétrique par rapport au plan médian 120, de sorte que la description qui va suivre des mâchoires 121b et 122b s'applique de manière symétrique aux mâchoires 121a et 122a.

On retrouve également sur cette figure les cassettes K2 et K3, ainsi que les bras 1210b et 1220b sur lesquels sont montées les mâchoires respectives 121 b et 122b.

La mâchoire 121b comprend deux parties de mâchoire1211b et 1212b, qui ont des géométries spécifiques que l'on va décrire ci-après.

Plus précisément, la première partie 1211b comprend deux membres 12111b et 12112b, qui sont agencés de part et d'autre de la deuxième partie 1212b selon la direction verticale.

La deuxième partie 1212b est en outre montée à translation horizontale parallèle à la longueur des mâchoires par rapport au support de mâchoire 1215b, par l'intermédiaire d'un organe de mise en translation contrôlée tel qu'une vis 12120b qui relie la deuxième partie au support de mâchoire, et dont on peut contrôler le déploiement.

Chaque membre 12111 b, 12112b, ainsi que la deuxième partie de mâchoire 1212b comportent une pluralité de logements concaves répartis de manière régulière selon le pas de référence mentionné précédemment.

Chacun des logements concaves des première et deuxième parties de la mâchoire comprend un élément saillant central tel qu'une arête qui court parallèlement à la direction du logement, destiné à engager un substrat au niveau de son plan de clivage.

Ainsi :
- chaque logement L11b du premier membre 12111 b de la première partie de mâchoire du premier peigne 121 comprend une arête A11b,
- chaque logement L12b du deuxième membre 12112b de la première partie de mâchoire du premier peigne 121 comprend une arête A12b,
- chaque logement L2b de la deuxième partie de mâchoire du premier peigne 121 comprend une arête A2b.

Chaque arête définit ainsi un plan général dans lequel elle s'étend, les arêtes étant toutes parallèles entre elles. Ledit plan dans lequel s'étendent les arêtes est un plan vertical, perpendiculaire à la surface de la mâchoire qui est destinée à se resserrer sur les substrats : ce plan est ainsi confondu avec le plan de clivage du substrat lorsque la mâchoire se referme sur le substrat.

On reviendra en référence à la figure 3 à la description détaillée de ces arêtes centrales et de leur rôle.

Le nombre de logements de chaque membre de la première partie de mâchoire, et de la deuxième partie de mâchoire est de préférence égal au nombre de logements de la nacelle N et des cassettes K2 et K3 de la figure 1.

Les logements sont répartis selon la longueur de chaque membre et de la deuxième partie de mâchoire.

Les deux membres 12111 b, 12112b sont fixes l'un par rapport à l'autre et par rapport au support de mâchoire 1215b, ces deux membres étant rigidement solidaires dudit support.

Chaque logement des membres 12111b et 12112b s'étend généralement selon la direction verticale qui correspond à la direction d'allongement des substrats et des tranches qui vont être manipulés. Il en est de même des logements de la deuxième partie 1212b de la mâchoire du premier peigne.

Et chaque logement du membre 12111 b s'étend dans le prolongement d'un logement correspondant du membre 12112b, ces deux logements correspondants étant destinés à se refermer sur le même substrat lors du resserrement des mâchoires du premier peigne121.

Plus précisément, chaque logement L11b L12b des membres respectifs 12111b et 12112b qui constituent la première partie de la mâchoire du peigne, présente en outre un profil asymétrique et comprend de part et d'autre de son arête centrale A11b, A12b :
- une première paroi orientée avec une première incidence générale par rapport au plan général dudit élément saillant, pour coopérer avec un premier côté du substrat que le logement doit recevoir lorsque les mâchoires se referment dessus, et
- une deuxième paroi orientée avec une deuxième incidence générale par rapport au plan général dudit élément saillant, qui est plus importante que ladite première : incidence générale, pour coopérer avec un deuxième côté du substrat.
La première incidence générale est faible, de l'ordre de quelques degrés, de sorte que la première paroi est quasiment perpendiculaire à la surface du membre qui la porte.
La deuxième incidence, quant à elle, est beaucoup plus importante, de sorte que la deuxième paroi définit une moitié de profil de logement plus « ouverte », cette deuxième paroi remontant très progressivement du fond du logement vers le sommet saillant de la première paroi du logement voisin. , Les arêtes centrales A11b, A12b sont destinées à s'engager dans le, substrat que le logement reçoit (on va expliquer ci-dessous comment chaque logement reçoit un substrat), au niveau du plan de clivage du substrat.
Cet engagement est réalisé lors du resserrement des mâchoires du premier peigne sur les substrats. La forme concave des logements et la présence de l'arête centrale permettent ainsi aux premières parties des mâchoires du premier peigne 121 d'engager chaque substrat entre ses deux tranches. Et du fait du profil asymétrique des logements, lors de ce resserrement, la tranche du substrat qui se trouve du premier côté du substrat dispose, par rapport aux premières parties 121 a, 121b du premier peigne et selon la direction perpendiculaire au plan général dudit élément saillant, d'un degré de liberté de mouvement moindre que celui dont dispose la tranche du substrat qui se trouve du deuxième côté du substrat.
En d'autres termes, lors de ce resserrement et par rapport aux premières parties du premier peigne, pour chaque substrat la tranche qui se trouve du premier côté du substrat est coincée entre l'arête centrale du logement et sa première paroi, qui présente une pente raide par rapport au fond du logement.
Et dans le même temps, l'autre tranche du substrat dispose d'un plus grand degré de liberté pour se déplacer par rapport aux premières parties du premier peigne selon la direction perpendiculaire au plan général dudit élément saillant, c'est à dire la direction perpendiculaire au plan de la tranche.
Ainsi, une des tranches du substrat se trouve coincée par rapport au membre qui l'engage, alors que l'autre tranche peut éventuellement se déplacer de manière à s'écarter de la première tranche.
On précise que les parois et les arêtes de chaque logement des premier et deuxième membres de la première partie du premier peigne sont alignés verticalement, de sorte que les deux membres ont le même effet sur chaque substrat.
Et de manière similaire, les logements L2b de la deuxième partie de mâchoire 1212b présentent également un profil asymétrique, par rapport à leur arête centrale A2b.
Ici encore, les arêtes centrales des logements sont destinées à engager les substrats au niveau de leur plan de clivage, lors du resserrement des deuxièmes parties de mâchoire du premier peigne sur les substrats.
On précise que lors de ce resserrement (qui dans une forme préférée de réalisation de l'invention est réalisé en même temps que le resserrement des premières parties de mâchoire du premier peigne, les mâchoires du premier peigne se refermant en une fois), les arêtes des premières et deuxièmes parties de mâchoire du premier peigne sont alignées verticalement.
On verra par ailleurs que cet alignement n'est vérifié que dans une position de référence entre les premières et deuxièmes parties de mâchoire du premier peigne 121, cette position de référence étant celle des parties de mâchoire lors du resserrement des mâchoires du premier peigne.
De la sorte, lors du resserrement du premier peigne sur les substrats, chaque substrat est engagé par les arêtes des premières et deuxièmes parties du premier peigne, au niveau de son plan de clivage.
Pour chaque logement de la deuxième partie de mâchoire du premier peigne, on retrouve de la même manière d'un côté de cette arête une paroi « raide » qui coince une tranche du substrat, et de l'autre côté une paroi « ouverte » qui laisse à l'autre tranche un certain degré de liberté en écartement de la première tranche coincée, par rapport à la deuxième partie 1212b.
Mais le profil des logements des deuxièmes parties du premier peigne est inversé par rapport au profil des logements des premières parties du premier peigne.
En effet, la paroi « raide » d'un logement de la deuxième partie de mâchoire du premier peigne se trouve alignée verticalement avec la paroi « ouverte » du logement correspondant des membres de première partie de mâchoire de premier peigne.
Et de manière symétrique, la paroi « ouverte » d'un logement de la deuxième partie se trouve aligné verticalement avec la paroi « raide » du logement correspondant des membres de première partie.
Ainsi, la tranche du substrat qui se trouve dudit premier côté du substrat, et qui est coincée par rapport à la première partie de mâchoire 1211 b entre l'arête centrale et la paroi « raide » des deux logements des membres 12111 b et 12112b, dispose d'un certain degré de liberté pour s'écarter de l'arête centrale A2b du logement correspondant de la deuxième partie de mâchoire 1212b, en écartement de cette arête.
Et l'autre tranche du substrat est quant à elle coincée par rapport à la deuxième partie de mâchoire, mais dispose d'un degré de liberté en écartement par rapport aux arêtes centrales des logements des membres de la première partie de mâchoire.
On a défini ci-dessus les principales caractéristiques structurelles de la machine 1, qui correspond à un premier mode principal de réalisation de machine selon l'invention.
On va maintenant décrire le fonctionnement de cette machine, en référence toujours aux figures 1 à 4.
Partant d'une situation dans laquelle :
- la nacelle N contient 25 substrats S qui ont subi un clivage (ledit clivage devant être achevé mécaniquement, ou non - en tout état de cause, on va selon l'invention décoller les deux tranches de chaque substrat),
- l'ensemble 12 se trouve en regard et à l'aplomb de la station ST1 (par suite d'un déplacement adapté selon la direction X de la figure 1), et
- les mâchoires des peignes 121 et 122 sont écartées et ouvertes, on commande tout d'abord l'ascension du poussoir associé à la station ST1.
Ce poussoir vient cueillir les substrats, chaque substrat étant reçu par un logement du poussoir (qui se trouve en dessous du substrat à cet effet, les logements ayant par ailleurs des pentes en « V » pour former entonnoir et recueillir un substrat).

On rappelle que le fond de chaque logement de ce poussoir comprend une arête centrale (définissant ainsi un profil de logement en « W »), cette arête venant ainsi se positionner dans la cavité annulaire du plan de clivage du substrat.

On précise qu'on entend par « forme en W » toute forme généralement concave, comprenant en outre un profil saillant dans le fond de la concavité.

La position du substrat par rapport au poussoir est ainsi automatiquement ajustée par coopération de formes (la cavité annulaire du plan de clivage venant sur la pointe du « W », et les pentes des bords - symétriques - des logements du poussoir étant par ailleurs suffisamment faible pour maintenir le substrat en position verticale).

Le poussoir de la station ST1 soulève ainsi les substrats jusqu'à une position haute, dans laquelle le centre des substrats se trouve à la hauteur du centre des deuxièmes parties - centrales selon la direction verticale - du premier peigne 121.

Dans cette position haute, les substrats se trouvent entre les deux mâchoires du peigne 121, qui sont écartées et ainsi ouvertes.

On commande alors le resserrement synchronisé et symétrique des mâchoires 121 a et 121 b du premier peigne 121, de manière à refermer les mâchoires de ce premier peigne sur les substrats.

Et les logements du premier peigne sont disposés de manière à recevoir chacun un substrat, lors de cette fermeture.

Toujours lors de cette fermeture, la coopération de formes des premières et deuxième parties de mâchoire du premier peigne provoque le dévoilement de chaque substrat en deux tranches disjointes.

En effet, comme expliqué ci-dessus lors de ce resserrement des premières et deuxièmes parties de mâchoire du premier peigne 121, les arêtes centrales des logements des ces différentes parties du premier peigne 121 maintiennent le plan de clivage de chaque substrat dans une position fixe par suite de leur engagement avec le substrat. ,

Et pour chaque substrat, une première tranche dispose d'un degré de liberté en écartement de l'autre tranche, par rapport aux premières parties de mâchoire de premier peigne, alors que l'autre tranche dispose d'un degré de liberté similaire par rapport aux deuxièmes parties de mâchoire de premier peigne.

Et les arêtes centrales des logements du premier peigne 121 jouant le rôle d'un coin qui est engagé dans le plan de clivage, ces degrés de liberté sont utilisés par les deux tranches de chaque substrat pour s'écarter l'une de l'autre et aboutir à un décollement complet du substrat.

Ainsi, une fonction de ces arêtes centrales des logements du premier peigne 121 est d'imposer de la sorte une position fixe au plan de clivage de chaque substrat, au niveau des première et deuxième parties du premier peigne 121, alors que les tranches de chaque substrat disposent par ailleurs d'un certain degré de liberté en écartement.

Ainsi, la coopération des formes des mâchoires du premier peigne sollicite en écartement les deux tranches de chaque substrat.

Cette fonction des arêtes centrales des logements du premier peigne 121 favorise grandement le décollement des deux tranches de chaque substrat ; dans les cas où le clivage des tranches est déjà « achevé » (c'est à dire que les tranches du substrat ne demeurent accolées que sous l'effet de forces du type « ventouse » ou Van der Waals), elle permet même de réaliser complètement le décollement des tranches, qui s'écartent l'une de l'autre grâce à leur liberté relative.

Lorsqu'au contraire le clivage des tranches présentées à la machine n'est pas « achevé », il est possible de prévoir que lors du resserrement ces arêtes ne servent qu'à positionner correctement les substrats.

Dans ce cas, la sollicitation en écartement évoquée ci-dessus n'est pas suffisante pour effectivement décoller les tranches et le décollement n'est effectivement réalisé que lors du déplacement en translation des deuxièmes parties de mâchoire de premier peigne d'un demi-pas de référence qui sera évoqué plus bas.

Il est également possible d'adapter les caractéristiques de la machine (forme des arêtes, force de resserrement, ...) pour, lors du resserrement, réaliser complètement le décollement des tranches, même sur un substrat pour lequel le clivage n'était pas achevé.

En tout état de cause, on pourra adapter la géométrie du profil de ces arêtes centrales, ainsi que la cinématique du resserrement des mâchoires, pour jouer sur les deux fonctions des arêtes (positionnement seul / positionnement et décollement par effet coin).

On pourra aussi adapter de manière désirée la cinématique du resserrement des mâchoires du premier peigne, afin de gérer au mieux le décollement des tranches sans risquer d'endommager les tranches.

En particulier, on pourra prévoir d'associer aux mâchoires du premier peigne des capteurs d'effort pour interrompre le resserrement des mâchoires en cas de résistance trop importante des substrats.

Dans un tel cas, un ou plusieurs substrats peuvent avoir du mal à se décoller et on peut choisir d'interrompre les opérations pour éviter d'endommager les substrats : on pourra identifier et prélever les substrats « résistants » et poursuivre le décollement avec les autres.

On pourra également associer à ce resserrement des capteurs d'un autre type, par exemple optiques, pour vérifier que le décollement se déroule correctement et stopper la machine si ce n'est pas le cas.

Le poussoir de ST1 est alors redescendu vide, et escamoté dans la base 11, de sorte que les substrats sont maintenus uniquement par les mâchoires.

On précise que dans le cas où les substrats à décoller comprennent une couche d'un matériau tel que le silicium (à l'intérieur de laquelle le plan de clivage du substrat est défini et qui comporte elle-même les deux tranches de part et d'autre du plan de clivage), collée sur un raidisseur, l'interface de collage entre la couche et le raidisseur peut aider au bon positionnement initial des arêtes centrales des logements du premier: peigne 121 au début du resserrement des mâchoires de ce peigne.

En effet, une telle interface de collage définit un chanfrein annulaire qui résulte d'un léger arrondi aux bords de la couche de silicium (ou d'un autre matériau) et du raidisseur (arrondis observés sur une coupe radiale d'un substrat en forme de galette).

Les deux arrondis se trouvant en regard l'un de l'autre définissent ainsi le chanfrein annulaire.

Et la Demanderesse a observé que les arêtes centrales des logements du premier peigne 121 venaient dans ce cas s'engager au niveau du chanfrein annulaire.

Cet engagement est facilité par le fait qu'au début du resserrement des mâchoires, les substrats disposent d'un certain degré de liberté selon la direction de rangement des substrats.

Et lors de la mise en contact des arêtes du premier peigne et des substrats, ces derniers auto-ajustent leur position selon la direction de rangement des substrats, pour favoriser cet engagement au niveau de l'interface de collage.

La Demanderesse a également observé que lorsqu'on poursuit le resserrement des mâchoires du premier peigne sur les substrats, le décollement s'effectue bien selon le plan de clivage.

On commande ensuite le déplacement en translation des deuxièmes parties de mâchoire de premier peigne, d'un demi-pas de référence.

Cette translation contrôlée est effectuée dans le sens de la flèche T de la figure 3 (c'est à dire dans une direction sensiblement parallèle à la direction de rangement des substrats), de sorte que lors de cette translation les parois « raides » des premières et deuxièmes parties qui sont associées à un même substrat, et qui se trouvent déjà de part et d'autre du substrat, s'écartent encore.

De la sorte, les arêtes centrales des logements des deuxièmes parties déplacent la tranche de chaque substrat qui était coincée dans lesdits logements, pour l'écarter encore de l'autre tranche du substrat.

Et comme on l'a dit, ce déplacement se fait sur une longueur qui correspond à un demi-pas de référence ; à ce stade les tranches sont donc régulièrement espacées d'un demi pas de référence, les deux tranches d'un même substrat présentant en regard l'une de l'autre leurs faces avant ou actives (faces issues du clivage).

Mais le premier peigne étant maintenant refermé sur les tranches (dont il a par ailleurs provoqué le décalage d'une tranche sur deux d'un demi-pas de référence), ce premier peigne maintient maintenant les tranches ainsi décalées.

Cette fonction de décalage contrôlé d'une tranche sur deux va permettre comme on va le voir d'enchaîner de manière particulièrement simple et aisée sur des étapes de manutention de la pluralité de tranches, après leur décollement.

On précise qu'il est évidemment possible de rendre mobile selon la direction de la flèche T non pas les deuxièmes parties de mâchoire du premier peigne, mais les premières parties de ces mâchoires, l'important étant de commander un mouvement contrôlé entre les deux parties.

L'ensemble 12 est ensuite déplacé selon la direction X de la figure 1 par ses moyens de commande, jusqu'à se trouver à l'aplomb de la station ST2. Le premier peigne 121 a emmené avec lui les 50 tranches qui sont régulièrement espacées d'un demi-pas de référence.

On commande ensuite l'ascension du poussoir associé à la station ST2, pour que celui-ci vienne au contact du bord inférieur des tranches, les 50 logements de ce poussoir décalés d'un demi-pas de référence recevant chacun une tranche.

Dans cette position, le poussoir associé à ST2 soutient les 50 tranches.

On commande alors l'ouverture des mâchoires du premier peigne 121, et la fermeture des mâchoires du second peigne 122 sur les tranches (pendant ces opérations les 50 tranches sont toujours soutenues par le poussoir de ST2).

Chacune des mâchoires 122a, 122b du deuxième peigne 122 comprend 25 dents D (voir figure 2) régulièrement espacées selon la longueur de la mâchoire, chaque dent étant séparée de la dent suivante par une longueur correspondant à un pas de référence.

Chaque dent comprend une fente évasée formant logement pour recevoir une tranche. On remarquera (en particulier sur la figure 1) que le peigne 122 étant en dessous du peigne 121 (qui se trouve quant à lui en regard de la région médiane des substrats et tranches lorsque ceux/celles-ci sont en position haute), les fentes des dents reçoivent les parties inférieures des tranches, et peuvent ainsi les soutenir.

Et lesdites fentes se trouvent en regard de tranches qui sont maintenues par le poussoir de ST2, une tranche sur deux étant reçue et maintenue dans une fente du deuxième peigne après la fermeture de celui-ci.

Les dents D sont par ailleurs séparées par des espaces E (voir encore figure 2), eux aussi régulièrement espacés selon le pas de référence.

Les dimensions de ces espaces béants sont telles qu'ils ne forment pas obstacle à la descente des tranches qui n'ont pas été reçues dans les fentes du peigne 122.

Le poussoir de ST2 est alors descendu, et 25 tranches restent maintenues en position haute par le peigne 122, alors que les 25 autres descendent avec le poussoir.

Le peigne 122 joue ainsi le rôle d'un « filtre » qui intercepte une tranche sur deux : seules les tranches n'ayant pas été décalées par la translation des deuxièmes parties de mâchoire de premier peigne sont reçues dans une fente de ce deuxième peigne.

Plus précisément, ce peigne conserve toujours la même tranche de chaque substrat (par exemple la tranche qui correspond au SOI ou au SOA), et il en est de même pour le poussoir de ST2 (qui conserve dans ce cas la tranche de chaque substrat qui correspond au reliquat de silicium).

Le poussoir de ST2 poursuit sa descente jusqu'à déposer les 25 tranches de reliquat dans la cassette K2 en la traversant, puis est escamoté dans la base 11.

L'ensemble 12 est ensuite déplacé en regard de la station ST3. Le deuxième peigne 122 déplace ainsi les 25 tranches qu'il porte, en regard de cette station.

Le poussoir associé à ST3 est déployé vers le haut, jusqu'à une position haute dans laquelle chacune des 25 tranches maintenues par le peigne 122 est reçue dans un logement de ce poussoir.

Le deuxième peigne 122 est alors ouvert, de sorte qu'il libère les 25 tranches (SOI ou SOA dans notre exemple), lesdites tranches demeurant maintenues par le poussoir de ST3.

Ce poussoir est ensuite descendu, pour traverser la cassette K3 et y déposer les 25 tranches de SOI ou SOA. Le poussoir de ST3 est ensuite escamoté dans la base 11.

Il apparaît ainsi que l'invention permet de réaliser de manière avantageuse le décollement de substrats, avec en particulier les avantages suivants :
- les cadences de traitement sont considérablement augmentées par rapport aux systèmes connus. L'invention permet en effet de décoller simultanément une pluralité de substrats (25 par exemple, bien que ce chiffre ne soit pas limitatif).
   On précise toutefois à cet égard qu'il est possible d'adapter la forme des mâchoires du premier peigne et/ou leur disposition, et/ou la cinématique de leur resserrement, pour que le décollement des substrats ne soit pas réalisé de manière simultanée (tous les substrats décollés en même temps), mais séquentielle (les substrats sont alors décollés les uns à la suite des autres, avec un décalage temporel contrôlé entre le décollement de deux substrats voisins).
   A cet effet, on pourra par exemple prévoir qu'en position refermée les mâchoires opposées du premier peigne ne soient pas parallèles, mais forment généralement un léger « V » dont l'angle au sommet est choisi pour que les mâchoires de ce peigne attaquent successivement les substrats les uns après les autres, lors de leur resserrement.
   Cette possibilité pourra en particulier être mise en oeuvre dans le cas de décollement de substrats dont le décollement est délicat. On pourra également dans ce cas associer au resserrement des mâchoires du premier peigne sur les substrats un capteur (optique ou autre) qui observe le substrat en cours de décollement (par exemple en se déplaçant selon la direction de rangement des substrats de manière à se trouver en regard d'un substrat lorsque celui-ci se décolle sous l'effet du resserrement des mâchoires), et permet par une boucle de retour adaptée d'interrompre ce resserrement en cas de problème observé sur un substrat en cours de décollement,
- le décollement est effectué avec un haut degré de précision, et de sécurité pour les tranches. En particulier, l'invention permet d'éviter les risques de rayures sur les faces des tranches décollées,
- l'invention permet également la manutention automatique des tranches décollées, les tranches respectives de chaque substrat étant rangées dans des cassettes prévues à cet effet,
- et les modalités de mise en oeuvre de l'invention peuvent être adaptées en fonction des substrats à décoller. En particulier, dans le cas de substrats dont le clivage n'est pas achevé et pour lesquels il est nécessaire de fournir un apport d'énergie supplémentaire pour permettre aux deux tranches de se décoller, on peut choisir de ne mettre en oeuvre le resserrement du premier peigne que pour positionner les substrats - ce qui favorise le décollement qui va suivre mais ne le fait pas aboutir, car la sollicitation en écartement des deux tranches qui résulte du resserrement n'est pas suffisante pour décoller les tranches - le décollement lui-même étant obtenu par le décalage d'un demi pas de référence entre les deux parties du premier peigne - les contraintes induites dans le substrat lors de ce décalage correspondant au surplus d'énergie nécessaire au décollement des tranches.

Il est bien évident que l'invention décrite ci-dessus peut être réalisée selon différentes variantes.

En particulier, il est possible de faire suivre le décollement réalisé au niveau de la station ST1, et le dégroupage des tranches qui suit ce décollement, du déchargement de la moitié des tranches (une tranche de chaque substrat) non pas sur la station ST2, mais sur la station d'extrémité ST3.

Dans ce cas, les deuxièmes tranches de chaque substrat seront déchargées par l'ensemble mobile 12, en ST2.

Ceci permet de terminer un cycle de décollement de la machine alors que ledit ensemble mobile se trouve en regard de la station médiane ST2.

Ceci permet également de choisir la tranche de substrat qui sera déposée à chaque station : dans le cas du décollement de substrats comprenant un SOI par exemple, on peut souhaiter déposer en ST2 les SOI, et en ST3 les reliquats de silicium.

Le deuxième peigne 122 retenant toujours les mêmes tranches, il faut alors adapter en conséquence le fonctionnement de la machine, en choisissant la première station de déchargement.

On précise également qu'il est possible de mettre en oeuvre une telle machine avec non pas trois, mais seulement deux stations.

Dans ce cas en effet, les stations ST2 et ST3 sont « confondues », une seule station étant prévue pour le déchargement des tranches décollées.

Dans ce cas, après le déchargement par la machine des premières tranches, un opérateur doit retirer la cassette qui vient d'être remplie en tranches, et placer à sa place une autre cassette - vide - qui recevra les autres tranches de la machine.

En référence maintenant aux figures 5 à 8, on va décrire une deuxième machine permettant de mettre en oeuvre l'invention selon un deuxième mode de réalisation principal.

La figure 5 est une vue d'ensemble schématique d'une telle machine 2, vue de dessus.

La machine 2 comprend ici encore une base fixe, référencée 21, et un ensemble mobile 22.

La base fixe 21 comprend trois stations principales ST'1, ST'2, ST'3.

La station ST'1 est une station de décollement ; elle peut accueillir une nacelle qui peut être similaire à la nacelle N de la figure 1, et on reprendra ici l'exemple du décollement (simultané ou non) de 25 substrats qui sont rangés de manière alignée selon un pas de référence.

La direction de rangement des substrats est indiquée par la flèche Y sur la figure 5.

Cette machine 2 est également adaptée au décollement de tous types de substrats (substrats de type SOI, SOA, mais également tout autre type ; substrats de taille indifférente). On pourra par exemple mettre en oeuvre une telle machine pour le décollement de tranches de SOI ou SOA d'un diamètre de 300 mm (sans que cet exemple soit limitatif).

La station ST'2 est une station de déchargement de tranches : elle peut accueillir une cassette qui peut être similaire aux cassettes déjà évoquées. Elle peut également accueillir une cassette fixe qui permet d'effectuer un basculement des tranches entre l'horizontale et la verticale.

Et la station ST'3 est une station de chargement des tranches qui ont été déchargées à la station ST'2. Cette station ST'3 comprend deux postes de chargement, chaque poste pouvant être occupé par un contenant de type Foup (selon l'acronyme anglo-saxon Front Opening Unified Pod) ou Fosb (selon l'acronyme anglo-saxon Front Opening Shipping Box).

Ces contenants permettent de stocker, comme des cassettes, une pluralité de tranches espacées selon un pas donné (ici notre pas de référence). Une de leurs spécificités est que dans de tels contenants, les tranches sont stockées horizontalement et non verticalement On précise en outre que les tranches sont stockées avec leurs faces actives tournées vers le haut.

Il est donc nécessaire d'associer également à la machine 2 des moyens 23 pour faire effectuer une rotation d'un quart de tour à la pluralité de tranches qui sont disposées verticalement dans la cassette de la station ST'2, pour coucher ces tranches horizontalement tout en conservant l'alignement des tranches et le pas de référence entre deux tranches voisines dans l'alignement.

L'ensemble 22 est quant à lui apte à être déplacé entre deux positions se trouvant respectivement en regard des stations ST'1 et ST'2, de manière contrôlée par des moyens de commande appropriés. Le déplacement de cet ensemble 22 se fait ainsi selon la direction X indiquée sur la figure 5.

La machine 2 comprend en outre un robot de manutention 24, qui assure le transfert des tranches décollées qui ont été déposées par l'ensemble 22 à la station ST'2 et couchées horizontalement suite à la rotation quart de tour subie en sortie de station ST'2, de cette station ST'2 jusqu'à la station ST'3.

Ce robot 24 est donc mobile en translation selon la direction Y. Il est également mobile en rotation autour de son propre axe vertical 240, pour permettre le déchargement des tranches dans les contenants de la station ST'3, il est également mobile en Z.

L'ensemble mobile 22 comprend un premier peigne dont les deux mâchoires, symétriquement opposées par rapport au plan médian 220 de l'ensemble, sont aptes à se refermer sur les tranches de la pluralité de substrats.

Mais dans ce cas, ce premier peigne est destiné à imposer aux tranches un décalage d'un demi-pas de référence : les logements qui sont prévus de manière régulièrement espacée sur chaque mâchoire du peigne pour recevoir chacun une tranche sont ainsi décalés d'un demi-pas de référence.

La section transversale des mâchoires opposées 221 a et 221 b du premier peigne 221 sont représentées schématiquement sur la vue de la figure 6, qui représente de manière schématique en élévation de face les principaux éléments de l'ensemble 22, avec un substrat S positionné dans cet ensemble.

On notera que dans le cas de cette deuxième machine, les mâchoires du premier peigne ne se referment pas par suite d'une rotation d'axe vertical, mais par le basculement de chaque mâchoire autour d'un axe horizontal respectif 2210a, 2210b.

Les mâchoires 221 a et 221 b peuvent ainsi pivoter autour de leur axe dédié, entre une position dans laquelle les tranches des substrats sont dégagées, et une position dans laquelle les mâchoires maintiennent les tranches (chaque tranche étant logée de part et d'autre de son axe médian vertical dans un logement correspondant d'une mâchoire).

C'est cette dernière position de maintien qui est illustrée sur la figure 6.

Ici encore, le basculement des deux mâchoires est synchronisé pour que les deux mâchoires restent symétriques de part et d'autre du plan médian 220.

Le premier peigne 221 est ainsi un préhenseur pour les tranches, après leur décollement. On reviendra sur cet aspect.

L'ensemble 22 comprend également deux éléments de séparation 222a et 222b, également montés à rotation autour d'axes horizontaux respectifs 2220a et 2220b de part et d'autre du plan médian 220.

Chacun de ces deux éléments de séparation comporte 25 éléments en lame, disposés selon la direction Y avec le pas de référence, de manière à se trouver chacun en regard du plan de clivage d'un substrat lorsque la pluralité de substrat est amenée (voir description détaillée ci-dessous).

Chacune des 25 lames de l'élément 222a est en regard d'une lame de l'élément 222b de sorte que les lames des deux éléments respectifs se trouvent en regard l'une de l'autre deux à deux, pour engager le plan de clivage d'un substrat des deux côtés.

Ces éléments de séparation peuvent basculer (eux aussi de manière symétrique) entre une position dans laquelle les substrats sont dégagés, et une position (représentée sur la figure 6) dans laquelle chaque lame attaque un plan de clivage d'un substrat S.

On trouve également sur la figure 6 un guide 223, qui est agencé dans la partie haute de l'ensemble 22, au-dessus des substrats.

Ce guide peut être monté à coulissement vertical sur des moyens 2230 tels que des rails (on verra dans la suite de ce texte que ces moyens 2230 ne sont pas obligatoires).

Il comporte une pluralité de logements pour recevoir la partie haute des substrats. Le guide 223 comporte ainsi 25 logements, espacés selon la direction Y avec le pas de référence.

Le détail de la géométrie des logements du guide 223 est exposé en figure 7.

Sur cette figure, on constate que chaque logement L223 comporte dans sa partie de fond une partie L2230 dont la largeur est tout juste supérieure à l'épaisseur du substrat S, et une partie L2231 évasée en forme de cône dans la partie du logement qui est située vers le substrat (vers le bas).

Et le schéma de principe de la figure 7 n'est bien sûr pas limitatif ; on pourra ainsi prévoir toute géométrie comprenant une région de forme généralement conique ou convergente; et une région de fond du logement - la transition entre les deux régions pouvant avoir toute forme adaptée.

La figure 6 représente également le poussoir P de la station ST'1. Ce poussoir comporte 25 logements espacés avec le pas de référence, toujours selon la direction Y.

Chaque logement du poussoir est destiné à accueillir un substrat. Le poussoir cueille les substrats dans la nacelle qui est disposée à la station ST'1, en traversant cette nacelle lors de l'ascension du poussoir, comme dans le cas du poussoir de la station ST1 décrite plus haut.

Une représentation détaillée du fond d'un logement LP du poussoir est donnée en figure 8. Cette figure montre que le logement LP a une section en forme générale de « V ». On précise que l'angle du « V » a été considérablement exagéré ; il peut être en réalité de l'ordre de 4 degrés.

Et plus précisément, la forme du logement est en « W », le fond du logement - symétrique - comprenant une arête AP pour s'engager dans le plan de clivage du substrat lors du soulèvement du substrat par le poussoir.

L'engagement de cette arête dans le plan de clivage permet ainsi (comme dans le cas du poussoir de ST1 décrit ci-dessus) d'ajuster par auto centrage la position du substrat lors de son soulèvement par le poussoir.

Revenant à l'ensemble mobile 22, cet ensemble comprend également un deuxième peigne (non représenté sur les figures), qui est l'homologue du deuxième peigne 122 de la première machine décrite ci-dessus.

Chacune des deux mâchoires opposées d'un tel peigne comporte ici encore :
- 25 logements espacés du pas de référence,
- et 25 espaces également espacés du même pas et intercalés entre les logements, pour laisser passer une tranche sur deux lorsqu'on abaisse au travers de ce peigne un ensemble de 50 tranches espacées d'un demi pas de référence.

Ce peigne peut se refermer de la même manière que le peigne 122, ou par basculement comme le premier peigne 221. II est indépendant du premier peigne 221, des moyens de commande spécifiques lui étant dédiés pour son ouverture et sa fermeture.

On va maintenant décrire le fonctionnement de cette deuxième machine.

Préalablement à cette description, on rappelle que cette deuxième machine est bien adaptée au décollement de substrats de grandes dimensions, pour lesquels il est important de stabiliser de la manière la plus contrôlée possible la position des substrats lors du décollement.

En effet, comme on va le voir si le premier peigne de la première machine 1 permettait à la fois de saisir les substrats et de les décoller, en exploitant la coopération de formes des éléments du peigne non seulement pour décoller les substrats, mais également pour assurer leur positionnement (les arêtes centrales des différents logements jouant à cet égard un rôle), dans le cas de la deuxième machine 2, on a prévu des moyens différents pour positionner les substrats, et pour les décoller.

On précise toutefois que cette deuxième machine peut être mise en oeuvre pour le décollement de substrats de tailles quelconques.

Partant donc d'une situation dans laquelle :
- la nacelle qui est à la station ST'1 contient 25 substrats S qui ont subi un clivage (qui ici encore doit être achevé, ou est déjà achevé - en tout état de cause l'invention va permettre de décoller les deux tranches de chaque substrat),
- l'ensemble 22 se trouve en regard et à l'aplomb de la station ST'1 (par suite d'un déplacement adapté selon la direction X de la figure 5), et
- les mâchoires des premier et deuxième peignes de la machine 2 sont ouvertes,
   on commande l'ascension du poussoir P de ST'1, afin que celui-ci cueille les 25 substrats de la nacelle.

Comme expliqué ci-dessus, du fait de la géométrie en « W » des logements du poussoir chaque substrat est auto centré au milieu de son logement, et maintenu sensiblement vertical.

Ce poussoir s'élève jusqu'à une position haute dans laquelle la partie supérieure de chaque substrat est logée dans un logement L223 du guide 223.

La géométrie en entonnoir des logements L223 permet de garantir que le haut du substrat pénètre dans la partie de fond du logement, qui fixe la position du haut du substrat.

Et la position du bas du substrat étant également fixée par l'arête de fond du logement du poussoir, on comprend qu'on contrôle ainsi précisément le positionnement de chaque substrat qui ne dispose ainsi d'aucun degré de liberté pour basculer ou bouger latéralement; ceci est particulièrement important dans le cas de substrats de grandes dimensions.

Cependant, on prend soin lors de cette introduction des substrats dans les logements du guide 223 de ne pas amener les substrats en butée verticale vers le haut, au fond du logement du guide (voir figure 7). Ceci permet d'éviter d'induire des contraintes dans les substrats, qui constituent des éléments extrêmement fins et fragiles.

La position des substrats étant assurée, on commande ensuite le basculement des éléments de séparation 222a et 222b, de manière à ce que les lames de ces éléments viennent au contact de la ceinture périphérique des substrats.

On précise qu'on contrôle à ce stade l'amplitude du basculement des éléments de séparation pour que ceux-ci ne pénètrent pas encore dans l'épaisseur des substrats ; les éléments de séparation ne servent alors qu'à constituer des moyens supplémentaires pour maintenir les substrats.

A ce stade, le contrôle de la position des substrats est total. Les substrats sont ainsi centrés exactement de la manière désirée.

On dégage ensuite le haut des substrats des logements L223 du guide 223. Ce dégagement peut résulter du soulèvement commandé du guide sur les moyens 2230, ou encore de l'abaissement commandé de l'ensemble formé par le poussoir P et les éléments de séparation (des moyens étant alors prévus pour assurer un tel abaissement).

On précise qu'un guide tel que le guide 223 peut également être mis en oeuvre avec la machine 1, décrite ci-dessus et représentée sur la figure 1. Un tel guide peut en effet aider à positionner de manière précise les substrats.

En tout état de cause, après le dégagement des substrats hors du guide, ceux-ci sont toujours positionnés de manière contrôlée par le poussoir et les éléments de séparation.

On commande alors un basculement supplémentaire des éléments de séparation vers l'intérieur des substrats, de manière à ce que les lames de ces éléments attaquent les substrats au niveau de leur plan de clivage.

Cette « attaque » peut consister à faire pénétrer la lame d'une profondeur de l'ordre du mm dans l'épaisseur de la ceinture périphérique du substrat. On commandera le basculement des éléments séparateurs pour obtenir la profondeur de pénétration désirée.

Et cette attaque résulte dans le décollement des deux tranches de chaque substrat. A cet égard, la section transversale des éléments de séparation peut être adaptée pour former un coin saillant que l'on enfonce dans le plan de clivage des substrats.

Le dégagement des substrats hors du guide permet en effet aux deux tranches de se décoller l'une de l'autre. Plus précisément, les deux tranches de chaque substrat, qui se trouvent décollées l'une de l'autre, retombent alors contre les flancs du fond du logement correspondant du poussoir P.

En effet, le seul élément de l'ensemble 22 avec lequel les tranches coopèrent alors sont les logements du poussoir P.

Et de par la forme générale en « V » de ces logements, les deux tranches de chaque substrat sont donc disposées en « V » au fond de leur logement LP, de part et d'autre de l'arête centrale du logement.

On précise que pendant l'attaque des substrats par les lames des éléments de séparation, des capteurs de mesure de force et/ou de course sont associés à ces éléments, pour mesurer respectivement la résistance des substrats au décollement (et/ou la progression des lames).

Et on pourra prévoir des moyens pour interrompre la pénétration des lames, ou pour adapter la cinématique de pénétration, en fonction de ces mesures.

On précise que comme dans le cas de la première machine décrite ci-dessus, dans le cas du décollement de substrats comportant une interface de collage (avec un raidisseur ou autre), l'attaque initiale des séparateurs est réalisée au niveau de ladite interface, un transfert de contraintes s'effectuant ensuite vers le plan de clivage.

Ensuite, on commande le basculement des mâchoires du premier peigne vers l'intérieur, de manière à ce que ces mâchoires se referment sur les 50 tranches séparées.

Les 50 logements de ces mâchoires étant espacés d'un demi pas de référence, ce resserrement des mâchoires du premier peigne sur les tranches :
- impose un décalage d'un demi pas de référence aux tranches,
- et maintient ensuite lesdites tranches rangées régulièrement selon
- un demi pas de référence, les faces actives des tranches d'un même substrat se faisant face (comme dans le cas de la machine 1).

Pour permettre aux tranches de venir de la sorte en décalage de demi pas de référence (c'est à dire qu'une tranche sur deux doit se déplacer d'un demi pas de référence selon la direction Y - qui correspond sensiblement à la direction de rangement des tranches et substrats et à la longueur des mâchoires), les entrées des logements des mâchoires du premier peigne sont évasées.

Et un autre élément qui favorise ce déplacement d'une tranche sur deux, est que les tranches se trouvent inclinées dans les logements du poussoir suite au décollement, et jouissent d'une certaine liberté de mouvement dans la direction Y.

Enfin, on précise qu'en association avec ce resserrement des mâchoires du premier peigne, on commande la descente du poussoir de manière à ce que celui-ci libère progressivement les tranches, et permettent à la fois leur redressement à la verticale et leur mise en décalage d'un demi pas de référence.

On dispose donc à ce stade des tranches rangées régulièrement avec un demi pas de référence de décalage, dans les mâchoires du premier peigne.

Le poussoir de ST'1 termine sa course vers le bas et est escamoté dans la base 21.

L'ensemble 22 est ensuite déplacé de la station ST'1 à la station ST'2, où il est positionné.

A cette station, on procède à un dégroupage des tranches (c'est à dire qu'on prélève une tranche sur deux pour la descendre dans la cassette de ST'2).

Ce dégroupage peut se faire de la même manière qu'exposé ci-dessus à propos de la machine 1, ici encore grâce au deuxième peigne et au poussoir de la station.

25 tranches sont ainsi descendues dans la cassette de ST'2, pendant que les 25 autres demeurent maintenues en position haute par le deuxième peigne.

Les moyens 23 font ensuite basculer les tranches (de manière à ce que leurs faces actives soient tournées vers le haut), et les présentant au robot 24.

Ce robot va ensuite déposer les tranches alors que celles-ci demeurent en position horizontale, dans l'un des contenants de la station ST'3.

Les 25 autres tranches sont ensuite reprise par le poussoir de ST'2 que l'on a remonté, le deuxième peigne s'ouvrant à cet effet.

On précise que le poussoir de ST'2 peut à cet effet avoir 50 logements décalés d'un demi pas de référence, les logements utilisés pour descendre les 25 premières tranches étant intercalés entre ceux utilisés pour descendre les 25 dernières tranches.

Il est également possible de monter ce poussoir mobile en translation selon la direction Y, et de commander sa translation d'un demi pas de référence selon cette direction pour venir en regard des tranches demeurant dans le deuxième peigne. Dans ce cas le poussoir de ST'2 peut ne comporter que 25 logements, espacés d'un pas de référence.

Et il est dans ce dernier cas également possible de prévoir que c'est le deuxième peigne qui peut être déplacé d'un demi pas de référence selon la direction Y.

De même, la cassette de la station ST'2 peut être décalée d'un demi pas de référence selon la direction Y pour recevoir les tranches.

Ce deuxième lot de tranches est ensuite manipulé par les moyens 23 pour être mises à l'horizontale, en subissant dans le même temps un retournement d'un demi tour pour se trouver face active en haut.

Et le robot 24 amène de la même manière que pour le premier lot de tranches, ces nouvelles tranches jusqu'à les déposer dans un contenant de la station ST'3.

On précise que dans ce deuxième mode principal de mise en oeuvre de l'invention, on peut adapter la configuration des différents éléments : ainsi, les axes de rotation des mâchoires du premier peigne 221, et du séparateur, peuvent être orientés différemment. En outre, on pourra également prévoir non pas seulement une paire d'éléments de séparation comme représenté sur la figure 6, mais plusieurs paires, la configuration des éléments de séparation pouvant être adaptée.

On comprend que cette deuxième machine permet d'atteindre les mêmes avantages que mentionnés ci-dessus à propos de la première machine.

Ici encore, on pourra adapter la forme, la disposition et/ou la cinématique de resserrement du peigne sur les substrats de manière à ce que le décollement des substrats ne se fasse pas simultanément, mais séquentiellement.

En outre, dans le cas de cette deuxième machine les moyens spécifiques de maintien des substrats et leur mode de mise en oeuvre permettent de stabiliser les substrats et de contrôler finement leur position, et d'effectuer ainsi le décollement de substrats de grandes dimensions avec un haut degré de sécurité.

On précise que bien qu'un des avantages de l'invention soit de permettre de décoller en même temps un nombre important de substrats en traitant des séries de substrats simultanément (ou avec un décalage temporel contrôlé), les différentes formes de l'invention peuvent même être mises en oeuvre pour le décollement individuel , de substrats pris séparément, étant donné que les configurations spécifiques des machines et les étapes de leur fonctionnement sont en elles-mêmes avantageuses : même dans ce mode de mise en oeuvre, les cadences se trouvent augmentées par rapport au décollement tel que pratiqué actuellement, en particulier à la main.

On comprend évidemment que l'invention n'est pas limitée aux modes de réalisation décrits en détail ci-dessus. L'homme du métier pourra ainsi adapter ses enseignements : par exemple, les mouvements relatifs des poussoirs et des autres éléments des machines décrites peuvent être obtenus non pas en montant/baissant les poussoirs vers certains éléments des machines (peignes, ...), mais en baissant/montant (respectivement) lesdits éléments.

## Revendications

1. Dispositif (1) de décollement de substrat (S), ledit substrat (S) comprenant deux tranches accolées définissant entre elles un plan de clivage, le dispositif comprend
- des moyens pour alimenter des moyens de décollement avec une pluralité de substrats (S) disposés selon une direction de rangement de substrats (S),
- des moyens de décollement (121) des tranches desdits substrats (S),
- et des moyens (1212b) pour réaliser un déplacement contrôlé de certaines tranches de substrats (S) après leur décollement selon une direction sensiblement parallèle à la direction de rangement des substrats (S),
**caractérisé en ce que**
- les moyens de décollement comprennent des mâchoires mobiles,
- les moyens de décollement du dispositif comprennent un premier ensemble de peigne (121) formant mâchoire comportant au moins deux mâchoires (121 a, 121 b) mobiles situées de part et d'autre d'un espace destiné à recevoir les substrats (S),
- les mâchoires (121a, 121b) étant aptes à maintenir les substrats (S) par suite du resserrement des mâchoires (121a, 121b) sur les substrats,
- chaque mâchoire (121a, 121b) comprenant elle-même une première (1211 b) et une deuxième (1212b) parties,
- les deux parties de chaque mâchoire comportant des logements (L11b, L12b, L2b) concaves correspondants pour recevoir et maintenir les substrats,
- la géométrie desdits logements (L11b, L12b, L2b) correspondants étant adaptée pour, suite au resserrement des première et deuxième parties des deux mâchoires sur les substrats(S), solliciter en écartement les deux tranches de chaque substrat (S) par coopération de formes des logements des premières parties des deux mâchoires et des deuxièmes parties des deux mâchoires(121a, 121b), respectivement,
et **en ce que** dans chaque mâchoire (121a, 121b) du premier ensemble de peigne, les logements concaves des première et deuxième parties de mâchoire comprennent un élément saillant central (A11b, A12b, A2b) tel qu'une arête, destiné à engager un substrat (S) au niveau de son plan de clivage, ledit élément saillant définissant un plan général dans lequel il s'étend.

2. Dispositif selon la revendication 1, **caractérisé en ce que** les deux mâchoires (121 a, 121b) du premier ensemble de peigne sont identiques.

3. Dispositif selon l'une des revendications 1 à 2, **caractérisé en ce que** dans chaque mâchoire du premier ensemble de peigne :
- chaque logement concave de la première partie de mâchoire (1211b) présente en outre un profil asymétrique et comprend de part et d'autre dudit élément saillant :
- une première paroi orientée avec une première incidence générale par rapport au plan général dudit élément saillant, pour coopérer avec un premier côté du substrat, et
- une deuxième paroi orientée avec une deuxième incidence générale par rapport au plan général dudit élément saillant, qui est plus importante que ladite première incidence générale, pour coopérer avec un deuxième côté du substrat,
- de sorte que lors du resserrement des premières parties des mâchoires (1211 b) du premier ensemble de peigne sur le substrat (S), la tranche du substrat (S) qui se trouve du premier côté du substrat dispose, par rapport auxdites premières parties et selon la direction perpendiculaire au plan général dudit élément saillant, d'un degré de liberté de mouvement moindre que celui dont dispose la tranche du substrat (S) qui se trouve du deuxième côté du substrat.

4. Dispositif selon la revendication 3, **caractérisé en ce que** dans chaque mâchoire (121 a, 121 b) du premier ensemble de peigne:
• chaque logement concave de la deuxième partie de mâchoire (1212b) présente en outre un profil asymétrique et comprend de part et d'autre dudit élément saillant :
Ø une première paroi orientée avec une première incidence générale par rapport au plan général dudit élément saillant, pour coopérer avec ledit deuxième côté dudit substrat, et
Ø une deuxième paroi orientée avec une deuxième incidence générale par rapport au plan général dudit élément saillant, qui est plus importante que ladite première incidence générale, pour coopérer avec ledit premier côté dudit substrat,
• de sorte que lors du resserrement des deuxièmes parties des mâchoires du premier ensemble de peigne sur le substrat (S), la tranche du substrat qui se trouve du deuxième côté du substrat (S) dispose, par rapport auxdites deuxièmes parties et selon la direction perpendiculaire au plan général dudit élément saillant, d'un degré de liberté de mouvement moindre que celui dont dispose la tranche du substrat qui se trouve du premier côté du substrat (S),
• de manière à solliciter les deux tranches en écartement lors du resserrement du premier ensemble de peigne (121) sur le substrat (S).

5. Dispositif selon l'une des revendications précédentes, **caractérisé en ce que** dans chaque mâchoire du premier ensemble de peigne la première partie comprend deux membres (12111 b, 12112b) agencés de part et d'autre de la deuxième partie (1212b).

6. Dispositif selon l'une des revendications précédentes, **caractérisé en ce que** dans chaque mâchoire du premier ensemble de peigne la deuxième partie est mobile par rapport à la première partie.

7. Dispositif selon la revendication 6, **caractérisé en ce que** les moyens (1212b) pour réaliser un déplacement contrôlé de certaines tranches de substrats (S) après leur décollement comprennent des moyens de déplacement relatif en translation de la deuxième partie de chaque mâchoire par rapport à la première partie de chaque mâchoire respective, selon une direction perpendiculaire au plan général dudit élément saillant.

8. Dispositif selon l'une des revendications précédentes, **caractérisé en ce que** le dispositif comprend en outre un deuxième ensemble de peigne (122), dont les mâchoires peuvent être resserrées sur les substrats (S) indépendamment des première et deuxième parties.

9. Dispositif selon la revendication 8, **caractérisé en ce que** le deuxième ensemble de peigne (122) comporte en outre une pluralité de passages pour laisser passer certaines tranches (S).

10. Dispositif selon l'une des revendications précédentes, **caractérisé en ce que** le dispositif comprend en outre trois stations, dont une première station pour recevoir au moins un substrat (S) à décoller, et deux stations pour recevoir chacune une tranche respective de chaque substrat (S) décollé.

11. Dispositif selon la revendication 10, **caractérisé en ce que** le ou les ensemble(s) de peigne (121, 122) est (sont) monté(s) mobile(s) par rapport aux stations et il est prévu des moyens pour déplacer le(s)dit(s) ensemble(s) de peigne (121, 122) en regard de chaque station, sélectivement.

12. Dispositif selon l'une des deux revendications précédentes, **caractérisé en ce que** chaque station est pourvue d'un poussoir respectif.

13. Dispositif selon la revendication 12, **caractérisé en ce que** le poussoir associé à la première station comporte des logements pour recevoir des substrats (S), le poussoir associé aux autres stations comportant des logements pour recevoir respectivement une des tranches issues du décollement de chaque substrat (S).

14. Dispositif selon la revendication 13, **caractérisé en ce que** chaque logement du poussoir associé à la première station comporte en outre un élément saillant dans sa région médiane, pour engagement au niveau du plan de clivage du substrat.

15. Procédé de décollement des tranches de substrat comportant un plan de clivage entre deux tranches **caractérisé en ce que** le procédé comprend les étapes consistant à :
• Mettre en oeuvre un dispositif selon l'une des revendications précédentes,
• Amener chaque substrat dans un espace de réception de substrat,
• Resserrer les première et deuxième parties des mâchoires (121) du premier ensemble de peigne (121) sur chaque substrat (S), de manière à maintenir chaque substrat (S) et solliciter en écartement les deux tranches de chaque substrat (S) par coopération de formes des logements des premières parties des deux mâchoires (121a, 121 b) et des deuxièmes parties des deux mâchoires (122a, 122b), respectivement.

16. Procédé selon la revendication 15, **caractérisé en ce que** lors dudit resserrement, la coopération de forme des logements des premières parties des deux mâchoires (121 a, 121 b) provoque en outre un décalage contrôlé entre les deux tranches de chaque substrat (S), selon une direction perpendiculaire au plan de clivage.

17. Procédé selon la revendication 16, **caractérisé en ce que** le décollement est réalisé lors dudit décalage contrôlé.

18. Procédé selon l'une des revendications 15 à 17, **caractérisé en ce que** suite audit resserrement on desserre les première et deuxième parties des mâchoires du premier ensemble de peigne de manière à relâcher les tranches séparées, et on resserre des mâchoires d'un deuxième ensemble de peigne, de manière à retenir uniquement certaines tranches de substrat.

19. Procédé selon la revendication 18, **caractérisé en ce que** on retient une tranche de chaque substrat, l'autre tranche étant récupérée par un poussoir, et pour chaque substrat décollé on dépose la première tranche décollée dans un premier contenant, et la deuxième tranche décollée dans un deuxième contenant.

20. Application d'un procédé selon l'une des revendications 15 à 19 précédentes, pour le décollement de substrats issus d'un procédé de type SMARTCUT®, une première tranche du substrat correspondant à un SOI, l'autre tranche correspondant à un reliquat de matériau semiconducteur tel que du silicium monocristallin.

21. Dispositif (2) de décollement de substrat (S), lesdits substrats (S) comprenant deux tranches accolées définissant entre elles un plan de clivage, le dispositif comprend :
• des moyens pour alimenter des moyens de décollement avec une pluralité de substrats (S) disposés selon une direction de rangement de substrats (S),
• des moyens de décollement (222a, 222b) des tranches desdits substrats,
• et des moyens (221a, 221b) pour réaliser un déplacement contrôlé de certaines tranches de substrats (S) après leur décollement selon une direction sensiblement parallèle à la direction de rangement des substrats (S),
**caractérisé en ce que** :
• les moyens de décollement comprennent un séparateur (222a, 222b) apte à être déplacé entre une position dans laquelle les substrats (S) sont dégagés du séparateur (222a, 222b), et une position dans laquelle les substrats (S) sont attaqués par le séparateur (222a, 222b),
• les moyens de déplacements comprennent un premier peigne (221 a, 221 b) dédié à la préhension des substrats (S) suite à l'attaque desdits substrats (S) par ledit séparateur (222a, 222b), et comportant au moins deux mâchoires mobiles,
• les mâchoires mobiles étant aptes à maintenir les substrats (S) par suite du resserrement des mâchoires mobiles sur les substrats (S),
• chaque mâchoire mobile comportant des logements espacés d'une manière désirée, de sorte que, suite au resserrement desdites mâchoires mobiles sur les substrats (S), les tranches des substrats (S) se trouvent espacées de la manière désirée.

22. Dispositif selon la revendication 21, **caractérisé en ce que** ledit séparateur (222a, 222b) a une section transversale en forme de coin saillant.

23. Dispositif selon l'une des revendications 21 à 22 précédentes, **caractérisé en ce que** le dispositif comprend au moins deux stations, dont une station dédiée au décollement et une station dédiée au déchargement des tranches décollées.

24. Dispositif selon la revendication 23, **caractérisé en ce que** chaque station est pourvue d'un poussoir respectif.

25. Dispositif selon la revendication 24, **caractérisé en ce que** le poussoir de la station dédiée au décollement comporte des logements destinés à recevoir les substrats, logements dont la section présente un profil de forme générale en « V ».

26. Dispositif selon la revendication 25, **caractérisé en ce que** la forme détaillée desdits logements du poussoir est en « W », une arête centrale étant prévue au fond de chaque logement.

27. Dispositif selon l'une des revendications 21 à 26, **caractérisé en ce que** le dispositif comprend également un deuxième peigne, dont les mâchoires peuvent être resserrées sur les substrats (S) indépendamment des première et deuxième parties.

28. Dispositif selon la revendication 27, **caractérisé en ce que** le deuxième peigne comporte en outre une pluralité de passages pour laisser passer certaines tranches.

29. Dispositif selon l'une des revendications 21 à 28 précédentes, **caractérisé en ce que** le dispositif comprend également un guide destiné à positionner les substrats de façon précise.

30. Procédé de décollement des tranches de substrat (S) comportant un plan de clivage entre deux tranches **caractérisé en ce que** le procédé comprend les étapes consistant à :
• Mettre en oeuvre un dispositif selon l'une des revendications 21 à 29 précédentes,
• Amener chaque substrat dans un espace de réception de substrat,
• Resserrer les parties du séparateur sur chaque substrat (S), de manière à réaliser le décollement des deux tranches de chaque substrat (S),
• Resserrer sur les tranches de substrat (S) décollées des mâchoires mobiles permettant de maintenir les tranches.

31. Procédé selon la revendication 30, **caractérisé en ce que** préalablement au resserrement des mâchoires on maintient les tranches décollées dans des logements de poussoir en forme générale de « V ».

32. Procédé selon l'une des revendications 30 à 31 précédentes, **caractérisé en ce que** préalablement au décollement on maintient les substrats (S) à l'aide d'un guide.

33. Procédé selon l'une des revendications 30 à 32 précédentes, **caractérisé en ce que** suite au resserrement desdites mâchoires permettant de maintenir les tranches, on resserre sur ces mêmes tranches d'autres mâchoires permettant de retenir seulement certaines tranches.

34. Procédé selon la revendication 33, **caractérisé en ce que** on retient une tranche de chaque substrat, l'autre tranche étant récupérée par un poussoir, et pour chaque substrat décollé on dépose la première tranche décollée dans un premier contenant, et la deuxième tranche décollée dans un deuxième contenant.

35. Application d'un procédé selon l'une des revendications 30 à 34 précédentes, pour le décollement de substrats issus d'un procédé de type SMARTCUT®, une première tranche du substrat correspondant à un SOI, l'autre tranche correspondant à un reliquat de matériau semiconducteur tel que du silicium monocristallin.

36. Dispositif selon l'une des revendications 1 à 14 et 21 à 29, **caractérisé en ce que** les moyens de décollement (121, 222a, 222b) permettent de réaliser un décollement simultané des tranches desdits substrats (S).

37. Dispositif selon l'une des revendications 1 à 14 et 21 à 29, **caractérisé en ce que** les moyens de décollement (121, 222a, 222b) permettent de réaliser un décollement séquentiel des tranches desdits substrats (S).

38. Dispositif selon l'une des revendications 1 à 14 et 21 à 29 et 36 à 37, **caractérisé en ce que** les moyens d'alimentation en substrats (S) comprennent un poussoir apte à soulever les substrats (S) rangés dans un support de type berceau.

## Claims

1. Apparatus (1) for splitting a substrate (S) apart, said substrate (S) comprising two adjoining wafers defining between them a cleavage plane, the apparatus comprising:
- means for feeding splitter means with a plurality of substrates (S) disposed in a substrate-storage direction;
- splitter means (121) for splitting apart the wafers of said substrates (S); and
- means (1212b) for performing controlled displacement of certain substrate wafers after they have been split apart in a direction that is substantially parallel to the substrate-storage direction, the apparatus being **characterized in that**:
- the splitter means include moving jaws;
- the splitter means of the apparatus comprise a first jaw-forming comb assembly (121) comprising at least two moving jaws (121 a, 121 b) situated on either side of a gap for receiving the substrates (S);
- the jaws (121a, 121b) being suitable for holding the substrates (S) once the jaws (121 a, 121 b) have clamped onto the substrates;
- each jaw (121a, 121 b) itself comprising first and second portions (1211b, 1212b);
- the two portions of each jaw having corresponding concave housings (L11b, L12b, L2b) for receiving and holding the substrates; and
- the shape of said corresponding housings (L11b, L12b, L2b) being adapted so that once the first and second portions of the two jaws have clamped onto the substrates (S), they urge the two wafers of each substrate (S) apart by co-operation between the shapes of the housings of the first portions of the two jaws and the second portions of the two jaws (121a, 121 b), respectively,
and **in that** in each jaw (121a, 121b) of the first comb assembly, each of the concave housings of the first and second jaw portions includes a respective projecting element (A11 b, A12b, A2b) such as an edge for engaging a substrate (S) at its cleavage plane, said projecting element defining a general plane in which it extends.

2. Apparatus according to claim 1, **characterized in that** the two jaws (121a, 121 b) of the first comb assembly are identical.

3. Apparatus according to claim 1 or claim 2, **characterized in that** in each jaw of the first comb assembly:
- each concave housing of the first jaw portion (1211 b) further presents a profile that is asymmetrical, comprising on either side of said projecting element:
□ a first wall oriented at a first general angle of incidence relative to the general plane of said projecting element to co-operate with a first side of the substrate; and
□ a second wall oriented with a second general angle of incidence relative to the general plane of said projecting element to co-operate with a second side of the substrate, which second angle of incidence is greater than said first general angle of incidence;
- such that during clamping of the first jaw (1211 b) portions of the first comb assembly on the substrate (S), the wafer of the substrate (S) that is on the first side of the substrate presents a degree of freedom to move relative to said first portions and in a direction perpendicular to the general plane of said projecting element that is smaller than the degree of freedom to move presented by the substrate wafer which is on the second side of the substrate.

4. Apparatus according to claim 3, **characterized in that** in each jaw (121a, 121 b) of the first comb assembly:
- each concave housing of the second jaw portion (1212b) further presents a profile that is asymmetrical and comprises, on either side of said projecting element:
□ a first wall oriented with a first general angle of incidence relative to the general plane of said projecting element to co-operate with said second side of said substrate; and
□ a second wall oriented with a second general angle of incidence relative to the general plane of said projecting element to co-operate with said first side of said substrate, which second angle of incidence is greater than said first general angle of incidence;
- such that during clamping of said second jaw portions of the first comb assembly on the substrate (S), the substrate wafer on the second side of the substrate (S) presents a degree of freedom to move relative to said second portions and in the direction perpendicular to the general plane of said projecting element that is smaller than the degree of freedom to move presented by the substrate wafer which is on the first side of the substrate (S); and
- so as to urge the two wafers apart during clamping of the first comb (121) assembly on the substrate (S).

5. Apparatus according to any preceding claim, **characterized in that** in each jaw of the first comb assembly, the first portion comprises two members (12111 b, 12112b) that are disposed on either side of the second portion (1212b).

6. Apparatus according to any preceding claim, **characterized in that** in each jaw of the first comb assembly, the second portion is movable relative to the first portion.

7. Apparatus according to claim 6, **characterized in that** the means (1212b) for achieving controlled displacement of certain substrate wafers after they have been split apart comprise means for moving the second portion of each jaw in translation relative to the first portion of each respective jaw in a direction perpendicular to the general plane of said projecting element.

8. Apparatus according to any preceding claim, **characterized in that** the apparatus further comprises a second comb assembly (122) having jaws that can be clamped onto the substrates (S) independently of the first and second portions.

9. Apparatus according to claim 8, **characterized in that** the second comb assembly (122) further includes a plurality of passages for allowing certain wafers (S) to pass through.

10. Apparatus according to any preceding claim, **characterized in that** the apparatus further comprises three stations, including a first station for receiving at least one substrate (S) to be split apart, and two stations, each for receiving a respective wafer from each split-apart substrate (S).

11. Apparatus according to claim 10, **characterized in that** the comb assembly(ies) (121, 122) is/are mounted to move relative to the stations and means are provided for displacing said comb assembly(ies) (121, 122) to be in register with each station, selectively.

12. Apparatus according to either one of the two preceding claims, **characterized in that** each station is provided with a respective pusher.

13. Apparatus according to claim 12, **characterized in that** the pusher associated with the first station has housings for receiving the substrates (S), the pusher associated with the other stations having housings for receiving respective ones of the wafers obtained by splitting apart each substrate (S).

14. Apparatus according to claim 13, **characterized in that** each housing of the pusher associated with the first station further includes a projecting element in its middle region for engaging the substrate at its cleavage plane.

15. A method of splitting apart the wafers of a substrate having a cleavage plane between two wafers, the method being **characterized in that** it comprises the steps consisting in:
- using apparatus according to any preceding claim;
- bringing each substrate into a substrate-receiving space; and
- clamping the first and second jaw portions (121) of the first comb assembly (121) onto each substrate (S) in such a manner as to hold each substrate (S) and urge apart the two wafers of each substrate (S) by co-operation between the shapes of the housings in the first portions of the two jaws (121a, 121b) and the second portions of the two jaws (122a, 122b), respectively.

16. A method according to claim 15, **characterized in that** during said clamping, co-operation between the shapes of the housings of the first portions of the two jaws (121a, 121b) also causes controlled offsetting between the two wafers of each substrate (S) in a direction perpendicular to the cleavage plane.

17. A method according to claim 16, **characterized in that** splitting occurs during said controlled offsetting.

18. A method according to any one of claims 15 to 17, **characterized in that** following said clamping, the first and second jaw portions of the first comb assembly are loosened so as to release the separated wafers, and the jaws of the second comb assembly are clamped together so as to retain only certain wafers of the substrate.

19. A method according to claim 18, **characterized in that** one wafer of each substrate is retained, with the other wafer being recovered by a pusher, and for each split substrate the first split-apart wafer is placed in a first container and the second split-apart wafer is placed in a second container.

20. The use of a method according to any one of preceding claims 15 to 19 for splitting apart substrates obtained by a Smartcut® type method, a first wafer of the substrate corresponding to an SOl wafer and the other wafer corresponding to a remainder of semiconductor material such as monocrystalline silicon.

21. Apparatus (2) for splitting a substrate (S) apart, said substrates (S) comprising two adjoining wafers defining between them a cleavage plane, the apparatus comprising:
- means for feeding splitter means with a plurality of substrates (S) disposed in a substrate-storage direction;
- splitter means (222a, 222b) for splitting apart the wafers of said substrates; and
- means (221 a, 221 b) for performing controlled displacement of certain substrate wafers after they have been split apart in a direction that is substantially parallel to the substrate-storage direction,
the apparatus being **characterized in that**:
- the splitter means comprise a separator (222a, 222b) suitable for being moved between a position in which the substrates (S) are disengaged from the separator (222a, 222b), and a position in which the substrates (S) are attacked by the separator (222a, 222b);
- the splitter means comprise a first comb (221 a, 221 b) dedicated to taking hold of the substrates (S) after said substrates (S) have been attacked by said separator (222a, 222b), and comprising at least two moving jaws;
- the moving jaws being suitable for holding the substrates (S) once the moving jaws have been clamped onto the substrates (S); and
- each moving jaw having housings that are spaced apart in a desired manner so that once said moving jaws have been clamped onto the substrates (S), the wafers of the substrates (S) are spaced apart in the desired manner.

22. Apparatus according to claim 21, **characterized in that** said separator (222a, 222b) has a cross-section in the form of a projecting wedge.

23. Apparatus according to preceding claim 21 or claim 22, **characterized in that** the apparatus comprises at least two stations, including a station dedicated to splitting substrates and a wafer dedicated to unloading the split-apart wafers.

24. Apparatus according to claim 23, **characterized in that** each station is provided with a respective pusher.

25. Apparatus according to claim 24, **characterized in that** the pusher of the station dedicated to splitting substrates has housings for receiving the substrates, which housings are of section presenting a generally V-shaped profile.

26. Apparatus according to claim 25, **characterized in that** the detailed shape of said pusher housings is a W-shape, a central edge being provided in the bottom of each housing.

27. Apparatus according to any one of claims 21 to 26, **characterized in that** the apparatus further comprises a second comb having jaws suitable for being clamped onto the substrates (S) independently of the first and second portions.

28. Apparatus according to claim 27, **characterized in that** the second comb further includes a plurality of passages for allowing certain wafers to pass through.

29. Apparatus according to any one of preceding claims 21 to 28, **characterized in that** the apparatus also comprises a guide for positioning the substrates in accurate manner.

30. A method of splitting apart substrate wafers having a cleavage plane between two wafers, the method being **characterized in that** it comprises the steps consisting in:
- using apparatus according to any one of claims 21 to 29;
- bringing each substrate into a substrate-reception space;
- clamping together the separator portions onto each substrate (S) so as to split apart the two wafers of each substrate (S); and
- clamping the moving jaws onto the split-apart substrate wafers so as to hold the wafers.

31. A method according to claim 30, **characterized in that** prior to clamping the jaws, the split-apart wafers are held in generally V-shaped housings of the pusher.

32. A method according to preceding claim 30 or claim 31, **characterized in that** prior to splitting the substrates apart, the substrates are held by means of a guide.

33. A method according to any one of preceding claims 30 to 32, **characterized in that** after said jaws have been clamped to hold the wafers, other jaws are clamped onto the same wafers enabling only certain wafers to be retained.

34. A method according to claim 33, **characterized in that** one wafer of each substrate is retained, the other wafer being recovered by a pusher, and for each split-apart substrate, the first split-apart wafer is placed in a first container and the second split-apart wafer is placed in a second container.

35. The use of a method according to any one of preceding claims 30 to 34, for splitting apart substrates obtained by a Smartcut® type method, a first wafer of the substrate corresponding to an SOI wafer and the other wafer corresponding to a remainder of semiconductor material such as monocrystalline silicon.

36. Apparatus according to any one of claims 1 to 14 and 21 to 29, **characterized in that** the splitter means (121, 222a, 222b) enable the wafers of said substrates (S) to be split apart simultaneously.

37. Apparatus according to any one of claims 1 to 14 and 21 to 29, **characterized in that** the splitter means (121, 222a, 222b) enable the wafers of said substrates (S) to be split apart sequentially.

38. Apparatus according to any one of claims 1 to 14 and 21 to 29 and 36 to 37, **characterized in that** the means for feeding substrates (S) comprise a pusher suitable for lifting substrates (S) stored in a cradle-type support.

## Patentansprüche

1. Vorrichtung (1) zum Abtrennen eines Substrats (S), wobei das Substrat (S) zwei aneinandergefügte Scheiben umfasst, die zwischen sich eine Spaltebene festlegen, wobei die Vorrichtung umfasst
- Mittel, um Abtrennmittel mit mehreren Substraten (S) zu versorgen, die entsprechend einer Anordnungsrichtung von Substraten (S) angeordnet sind,
- Mittel zum Abtrennen (121) der Scheiben der Substrate (S),
- und Mittel (1212b), um eine kontrollierte Bewegung bestimmter Scheiben von Substraten (S) nach ihrem Abtrennen entsprechend einer Richtung im wesentlichen parallel zur Anordnungsrichtung der Substrate (S) durchzuführen,
**dadurch gekennzeichnet, dass**
- die Abtrennmittel bewegliche Backen umfassen,
- die Abtrennmittel der Vorrichtung eine erste backenbildende Kammeinheit (121) umfassen, die wenigstens zwei bewegliche Backen (121a, 121b) umfasst, die auf beiden Seiten eines Raums liegen, der dazu bestimmt ist, die Substrate (S) aufzunehmen,
- wobei die Backen (121a, 121b) geeignet sind, die Substrate (5) zu halten infolge des Zusammendrückens der Backen (121a, 121b) auf die Substrate,
- wobei jede Backe (121a, 121b) selbst einen ersten (1211b) und einen zweiten Teil (1212b) umfasst,
- wobei die beiden Teile jeder Backe entsprechende konkave Aufnahmen (L11b, L12b, L2b) umfassen, um die Substrate aufzunehmen und zu halten,
- wobei die Geometrie der entsprechenden Aufnahmen (L11b, L12b, L2b) angepasst ist, im Anschluss an das Zusammendrücken des ersten und zweiten Teils der beiden Backen auf die Substrate (S), die beiden Scheiben jedes Substrats (S) durch Zusammenwirken von Formen der Aufnahmen der ersten Teile der beiden Backen bzw. der zweiten Teile der beiden Backen (121a, 121b) zur Trennung zu beanspruchen,
und dadurch, dass in jeder Backe (121a, 121b) der ersten Kammeinheit die konkaven Aufnahmen des ersten und zweiten Backenteils ein zentrales vorspringendes Element (A11b, A12b, A2b), z.B. eine Kante umfassen, das dazu bestimmt ist, an einem Substrat (S) auf Höhe seiner Spaltebene anzusetzen, wobei das vorspringende Element eine Hauptebene festlegt, in der es sich erstreckt.

2. Vorrichtung gemäß Anspruch 1, **dadurch gekennzeichnet, dass** die beiden Backen (121a, 121b) der ersten Kammeinheit identisch sind.

3. Vorrichtung gemäß einem der Ansprüche 1 bis 2, **dadurch gekennzeichnet, dass** in jeder Backe der ersten Kammeinheit:
- jede konkave Aufnahme des ersten Backenteils (1211b) außerdem ein asymmetrisches Profil aufweist und auf beiden Seiten des vorspringenden Elements umfasst :
- eine erste Wand, die mit einem ersten Hauptanstellwinkel bzgl. der Hauptebene des vorspringenden Elements ausgerichtet ist, um mit einer ersten Seite des Substrate zusammenzuwirken, und
- eine zweite Wand, die mit einem zweiten Hauptanstellwinkel bzgl. der Hauptebene des vorspringenden Elements, der wichtiger als der erste Hauptanstellwinkel ist, ausgerichtet ist, um mit einer zweiten Seite des Substrats zusammenzuwirken.
- derart, damit beim Zusammendrücken der ersten Teile der Backen (1211b) der ersten Kammeinheit auf das Substrat (S), die Scheibe des Substrats (S), die sich auf der ersten Seite des Substrats befindet, bzgl. der ersten Teile und entsprechend der Richtung senkrecht zur Hauptebene des vorspringenden Elements, über einen geringeren Hewegungsfreiheitsgrad als den verfügt, über den die Scheibe des Substrats (S) verfügt, die sich auf der zweiten Seite des Substrats befindet.

4. Vorrichtung gemäß Anspruch 3, **dadurch gekennzeichnet, dass** in jeder Backe (121a, 121b) der ersten Kammeinheit:
- jede konkave Aufnahme des zweiten Backenteils (1212b) außerdem ein asymmetrisches Profil aufweist und auf beiden Seiten des vorspringenden Profils umfasst:
* eine erste Wand, die mit einem ersten Hauptanstellwinkel bzgl. der Hauptebene des vorspringenden Elements ausgerichtet ist, um mit der zweiten Seite des Substrats zusammenzuwirken, und
* eine zweite Wand, die mit einem zweiten Hauptanstellwinkel bzgl. der Hauptebene des vorspringenden Elements ausgerichtet ist, der wichtiger als der erste Hauptanstellwinkel ist, um mit der ersten Seite des Substrats zusammenzuwirken,
- derart, damit beim Zusammendrücken der zweiten Teile der Backen der ersten Kammeinheit auf das Substrat (S) die Scheibe des Substrats, die sich auf der zweiten Seite des Substrats (S) befindet, bzgl. der zweiten Teile und entsprechend der Richtung senkrecht zur Hauptebene des vorspringenden Elements über einen geringeren Bewegungsfreiheitsgrad als den verfügt, über den die Scheibe des Substrats verfügt, die sich auf der ersten Seite des Substrats (S) befindet,
- um die beiden Scheiben beim Zusammendrücken der ersten Kammeinheit (121) auf das Substrat (S) zur Trennung zu beanspruchen.

5. Vorrichtung gemäß einem der vorhergehenden Ansprüche, **dadurch gekennzeichnet, dass** in jeder Backe der ersten Kammeinheit der erste Teil zwei Glieder (12111b, 12112b) umfasst, die auf beiden Seiten des zweiten Teils (1212b) angeordnet sind.

6. Vorrichtung gemäß einem der vorhergehenden Ansprüche, **dadurch gekennzeichnet, dass** in jeder Backe der ersten Kammeinheit der zweite Teil bzgl. des ersten Teils beweglich ist.

7. Vorrichtung gemäß Anspruch 6, **dadurch gekennzeichnet, dass** die Mittel (1212b), um eine kontrollierte Bewegung bestimmter Scheiben von Substraten (S) nach ihrem Abtrennen durchzuführen, Mittel der Bewegung relativ in Verschiebung des zweiten Teils jeder Backe bzgl. des ersten Teils jeder jeweiligen Backe, entsprechend einer Richtung senkrecht zur Hauptebene des vorspringenden Elements umfassen.

8. Vorrichtung gemäß einem der vorhergehenden Ansprüche, **dadurch gekennzeichnet, dass** die Vorrichtung außerdem eine zweite Kammeinheit (122) umfasst, deren Backen auf die Substrate (S) unabhängig vom ersten und zweiten Teil zusammengedrückt werden können.

9. Vorrichtung gemäß Anspruch 8, **dadurch gekennzeichnet, dass** die zweite Kammeinheit (122) außerdem mehrere Durchgänge umfasst, um bestimmte Scheiben (S) durchgehen zu lassen.

10. Vorrichtung gemäß einem der vorhergehenden Ansprüche, **dadurch gekennzeichnet, dass** die Vorrichtung außerdem drei Stationen umfasst, von denen eine erste Station ausgelegt ist, wenigstens ein abzutrennendes Substrat (S) aufzunehmen, und zwei Stationen ausgelegt sind, um jede eine jeweilige Scheibe von jedem abgetrennten Substrat (S) aufzunehmen.

11. Vorrichtung gemäß Anspruch 10, **dadurch gekennzeichnet, dass** das oder die Kammeinheit (en) (121, 122) bzgl. der Stationen beweglich montiert ist/sind und Mittel vorgesehen sind, um das/die Kammeinheit(en) (121, 122) wahlweise gegenüber jeder Station zu bewegen.

12. Vorrichtung gemäß einem der beiden vorhergehenden Ansprüche, **dadurch gekennzeichnet, dass** jede Station mit einer jeweiligen Druckvorrichtung ausgestattet ist.

13. Vorrichtung gemäß Anspruch 12, **dadurch gekennzeichnet, dass** die zur ersten Station gehörige Druckvorrichtung Aufnahmen umfasst, um Substrate (S) aufzunehmen, wobei die zu den anderen Stationen gehörige Druckvorrichtung Aufnahmen umfasst, um jeweils eine der Scheiben aufzunehmen, die vom Abtrennen jedes Substrats (S) stammen.

14. Vorrichtung gemäß Anspruch 13, **dadurch gekennzeichnet, dass** jede Aufnahme der zur ersten Station gehörigen Druckvorrichtung außerdem ein vorspringendes Element in seiner Mittelebene zum Ansetzen auf Höhe der Spaltebene des Substrats umfasst.

15. Verfahren zum Abtrennen der Scheiben eines Substrats, die eine Spaltebene zwischen zwei Scheiben umfassen, **dadurch gekennzeichnet, dass** das Verfahren die folgenden Schritte umfasst:
- Verwenden einer Vorrichtung gemäß einem der vorhergehenden Ansprüche,
- Zuführen jedes Substrats in einen Substrataufnahmeraum,
- Zusammendrücken des ersten und zweiten Teils der Backen (121) der ersten Kammeinheit (121) auf jedes Substrat (S), um jedes Substrat (S) zu halten und die beiden Scheiben jedes Substrats (S) durch Zusammenwirken von Formen der Aufnahmen der ersten Teile der beiden Backen (121a, 121b) bzw. der zweiten Teile der beiden Backen (122a, 122b) zur Trennung zu beanspruchen.

16. Verfahren gemäß Anspruch 15, **dadurch gekennzeichnet, dass** beim Zusammendrücken das Zusammenwirken der Form der Aufnahmen der ersten Teile der beiden Backen (121a, 121b) außerdem eine kontrollierte Verschiebung zwischen den beiden Scheiben jedes Substrats (S) entsprechend einer Richtung senkrecht zur Spaltebene verursacht.

17. Verfahren gemäß Anspruch 16, **dadurch gekennzeichnet, dass** das Abtrennen bei der kontrollierten Verschiebung durchgeführt wird.

18. Verfahren gemäß einem der Ansprüche 15 bis 17, **dadurch gekennzeichnet, dass** man im Anschluss an das Zusammendrücken die ersten und zweiten Teile der Backen der ersten Kammeinheit löst, um die getrennten Scheiben zu lockern, und man Backen einer zweiten Kammeinheit zusammendrückt, um nur bestimmte Substratscheiben zurückzuhalten.

19. Verfahren gemäß Anspruch 18, **dadurch gekennzeichnet, dass** man eine Scheibe jedes Substrats zurückhält, wobei die andere Scheibe durch eine Druckvorrichtung wiedererlangt wird, und man für jedes abgetrennte Substrat die erste abgetrennte Scheibe in einen ersten Behälter und die zweite abgetrennte Scheibe in einen zweiten Behälter ablegt.

20. Anwendung eines Verfahrens gemäß einem der vorhergehenden Ansprüche 15 bis 19, zum Abtrennen von Substraten, die aus einem Verfahren vom Typ SMARTCUT® stammen, wobei eine erste Scheibe des Substrats einem SOI entspricht, und die andere Scheibe einer Restauflage aus Halbleitermaterial, z.B. aus monokristallinem Silizium, entspricht.

21. Vorrichtung (2) zum Abtrennen eines Substrats (S), wobei die Substrate (S) zwei aneinandergefügte Scheiben umfassen, die zwischen sich eine Spaltebene festlegen, wobei die Vorrichtung umfasst:
- Mittel, um Abtrennmittel mit mehreren Substraten (S) zu versorgen, die entsprechend einer Anordnungsrichtung von Substraten (S) angeordnet sind,
- Mittel zum Abtrennen (222a, 222b) der Scheiben der Substrate,
- und Mittel (221a, 221b), um eine kontrollierte Bewegung bestimmter Scheiben von Substraten (S) nach ihrem Abtrennen entsprechend einer Richtung im wesentlichen parallel zur Anordnungsrichtung der Substrate (S) durchzuführen,
**dadurch gekennzeichnet, dass**
- die Mittel zum Abtrennen einen Trenner (222a, 222b) umfassen, der geeignet ist, zwischen einer Position, in der die Substrate (S) vom Trenner (222a, 222b) befreit sind, und einer Position, in der die Substrate (S) vom Trenner (222a, 222b) angegriffen werden, bewegt zu werden.
- die Bewegungsmittel einen ersten Kamm (221a, 221b) umfassen, der zum Ergreifen der Substrate (S) im Anschluss an den Angriff der Substrate (S) durch den Trenner (222a, 222b) bestimmt ist und wenigstens zwei bewegliche Backen umfasst,
- wobei die beweglichen Backen geeignet sind, die Substrate (S) zu halten im Anschluss an das Zusammendrücken der beweglichen Backen auf die Substrate (S),
- wobei jede bewegliche Backe auf eine gewünschte Weise beabstandete Aufnahmen umfasst, damit im Anschluss an das Zusammendrücken der beweglichen Backen auf die Substrate (S) die Scheiben der Substrate (S) sich auf die gewünschte Weise beabstandet befinden.

22. Vorrichtung gemäß Anspruch 21, **dadurch gekennzeichnet, dass** der Trenner (222a, 222b) einen Querschnitt in Form einer vorspringenden Ecke hat.

23. Vorrichtung gemäß einem der vorhergehenden Ansprüche 21 bis 22, **dadurch gekennzeichnet, dass** die Vorrichtung wenigstens zwei Stationen umfasst, von denen eine Station zum Abtrennen bestimmt ist, und eine Station zur Abgabe der abgetrennten Scheiben bestimmt ist.

24. Vorrichtung gemäß Anspruch 23, **dadurch gekennzeichnet, dass** jede Station mit einer jeweiligen Druckvorrichtung ausgestattet ist.

25. Vorrichtung gemäß Anspruch 24, **dadurch gekennzeichnet, dass** die Druckvorrichtung der zum Abtrennen bestimmten Station Aufnahmen umfasst, die dazu bestimmt sind, die Substrate aufzunehmen, Aufnahmen, deren Querschnitt ein Profil in hauptsächlicher Form eines "v" aufweist.

26. Vorrichtung gemäß Anspruch 25, **dadurch gekennzeichnet, dass** die detaillierte Form der Aufnahmen der Druckvorrichtung in Form eines "w" ist, wobei eine zentrale Kante am Boden jeder Aufnahme vorgesehen ist.

27. Vorrichtung gemäß einem der Ansprüche 21 bis 25, **dadurch gekennzeichnet, dass** die Vorrichtung auch einen zweiten Kamm umfasst, dessen Backen auf die Substrate (S) unabhängig vom ersten und zweiten Teil zusammengedrückt werden können.

28. Vorrichtung gemäß Anspruch 27, **dadurch gekennzeichnet, dass** der zweite Kamm außerdem mehrere Durchgänge umfasst, um bestimmte Scheiben durchgehen zu lassen.

29. Vorrichtung gemäß einem der vorhergehenden Ansprüche 21 bis 28, **dadurch gekennzeichnet, dass** die Vorrichtung auch eine Führung umfasst, die dazu bestimmt ist, die Substrate auf präzise weise zu positionieren.

30. Verfahren zum Abtrennen der Scheiben eines Substrats (5), die eine Spaltebene zwischen zwei Scheiben umfassen, **dadurch gekennzeichnet, dass** das Verfahren die folgenden Schritte umfasst:
- Verwenden eines Vorrichtung gemäß einem der vorhergehenden Ansprüche 21 bis 29,
- Zuführen jedes Substrats in einen Substrataufnahmeraum,
- Zusammendrücken der Teile des Trenners auf jedes Substrat (S), um das Abtrennen der beiden Scheiben jedes Substrats (S) durchzuführen,
- Zusammendrücken beweglicher Backen auf die abgetrennten Scheiben des Substrats (S), die erlauben, die Scheiben zu halten.

31. Verfahren gemäß Anspruch 30, **dadurch gekennzeichnet, dass** man vor dem Zusammendrücken der Backen die abgetrennten Scheiben in Druckvorrichtungsaufnahmen in hauptsächlicher Form eines "V" hält.

32. Verfahren gemäß einem der vorhergehenden Ansprüche 30 bis 31, **dadurch gekennzeichnet, dass** man vor dem Abtrennen die Substrate (S) mit Hilfe einer Führung hält.

33. Verfahren gemäß einem der vorhergehenden Ansprüche 30 bis 32, **dadurch gekennzeichnet, dass** man im Anschluss an das Zusammendrücken der Backen, die erlauben, die Scheiben zu halten, auf diese selben Scheiben andere Backen zusammendrückt, die erlauben, nur bestimmte Scheiben zu halten.

34. verfahren gemäß Anspruch 33, **dadurch gekennzeichnet, dass** man eine Scheibe jedes Substrats zurückhält, wobei die andere Scheibe durch eine Druckvorrichtung wiedererlangt wird, und man für jedes abgetrennte Substrat die erste abgetrennte Scheibe in einen ersten Behälter ablegt und die zweite abgetrennte Scheibe in einen zweiten Behälter.

35. Anwendung eines Verfahrens gemäß eines der vorhergehenden Ansprüche 30 bis 34, zum Abtrennen von Substraten, die aus einem Verfahren von Typ SMARTCUT® stammen, wobei eine erste Scheibe des Substrats einem SOI entspricht, und die andere Scheibe einer Restauflage aus Halbleitermaterial, z.B. aus monokristallinem Silizium, entspricht.

36. Vorrichtung gemäß einem der Ansprüche 1 bis 14 und 21 bis 29, **dadurch gekennzeichnet, dass** die Abtrennmittel (121, 222a, 222b) erlauben, ein gleichzeitiges Abtrennen der Scheiben der Substrate (S) durchzuführen.

37. Vorrichtung gemäß einem der Ansprüche 1 bis 14 und 21 bis 29, **dadurch gekennzeichnet, dass** die Abtrennmittel (121, 222a, 222b) erlauben, ein sequentielles Abtrennen der Scheiben der Substrate (S) durchzuführen.

38. Vorrichtung gemäß einem der Ansprüche 1 bis 14 und 21 bis 29 und 36 bis 37, **dadurch gekennzeichnet, dass** die Mittel zur Versorgung mit Substraten (S) eine Druckvorrichtung umfassen, die geeignet ist, die in einem Träger vom Typ Ablaufschlitten angeordneten Substrate (S) anzuheben.
